(19) Europäisches Patentamt
European Patent Office
Office européen des brevets

(11) **EP 2 766 996 B1**

(12) **FASCICULE DE BREVET EUROPEEN**

(45) Date de publication et mention de la délivrance du brevet:
**20.07.2016 Bulletin 2016/29**

(21) Numéro de dépôt: **12780243.7**

(22) Date de dépôt: **11.10.2012**

(51) Int Cl.:
*H03M 13/11* *(2006.01)*    *H03M 13/29* *(2006.01)*
*H03M 13/00* *(2006.01)*

(86) Numéro de dépôt international:
**PCT/FR2012/052320**

(87) Numéro de publication internationale:
**WO 2013/054054 (18.04.2013 Gazette 2013/16)**

(54) **CODAGE ET DECODAGE CORRECTEUR D'ERREURS**

FEHLERKORREKTURCODIERUNG UND -DECODIERUNG

ERROR CORRECTION CODING AND DECODING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.10.2011 FR 1159323**

(43) Date de publication de la demande:
**20.08.2014 Bulletin 2014/34**

(73) Titulaire: **Orange**
**75015 Paris (FR)**

(72) Inventeurs:
• **CARLACH, Jean-Claude**
**F-35000 Rennes (FR)**
• **OUESLATI, Brahim**
**Ville Saint Laurent, Québec H4N 1E6 (CA)**

(74) Mandataire: **Vidon Brevets & Stratégie**
**16B, rue de Jouanet**
**B.P. 90333**
**Technopole Atalante**
**35703 Rennes Cedex 7 (FR)**

(56) Documents cités:
• **HEHN T ET AL: "Multiple-bases belief-propagation decoding of high-density cyclic codes", IEEE TRANSACTIONS ON COMMUNICATIONS, vol. 58, no. 1, 1 janvier 2010 (2010-01-01), pages 1-8, XP011300484, ISSN: 0090-6778, DOI: 10.1109/TCOMM.2010.01.070468**
• **ADDE P ET AL: "Near maximum likelihood soft-decision decoding of a particular class of rate-1/2 systematic linear block codes", ELECTRONICS LETTERS, vol. 47, no. 4, 17 février 2011 (2011-02-17), pages 259-260, XP006038052, ISSN: 1350-911X, DOI: 10.1049/EL:20107857**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**1. Domaine de l'invention**

Le domaine de l'invention est celui du codage et du décodage de données, mettant en oeuvre un code correcteur d'erreurs.

Plus précisément, l'invention propose une nouvelle technique de codage de données source, délivrant des paquets de données codées ou un flux de données codées comprenant les données source et des données de redondance, destiné(s) à être transmis sur un canal de transmission (par exemple de type hertzien, optique ou électrique), ou stocké(s) dans un support matériel. L'invention concerne également une technique de décodage correspondante, permettant notamment de corriger les erreurs de transmission inhérentes au canal de transmission.

L'invention trouve notamment des applications dans les domaines suivants :

- la transmission d'information par télécommunications filaires électriques, comme dans les normes ADSL, ou optiques, sur fibres optiques ou en espace libre ;
- la transmission d'information dans les communications radios spatiales et terrestres sans fil (« wireless » en anglais), comme dans les systèmes de télévision numérique TNT, de radio numérique DAB, de téléphonie GSM ou UMTS, de réseau radio WiFi, et aussi dans les futurs systèmes de communications, comme les futures normes DVB, 4G, LTE, « Internet du futur », ou entre véhicules, objets ou machines communicants ... ;
- la compression et la décompression de source d'informations ;
- la génération et la détection de séquences dites d'embrouillage (« scrambling » en anglais) dans les systèmes CDMA ;
- le stockage d'informations dans des mémoires de masse magnétiques, optiques, mécaniques ou électriques pour constituer des disques durs, ou des mémoires vives d'ordinateurs, ou des clés mémoire à interface de type USB... ;
- la correction d'informations lors des calculs dans un circuit intégré d'un microprocesseur ou dans un ordinateur ;
- la robotique commandée par une intelligence artificielle à base de réseaux de neurone ;
- etc.

**2. Art antérieur**

De nombreuses techniques de codage permettent la correction d'erreurs de transmission au décodage en générant des données de redondance à partir de données source.

Ainsi, un code correcteur d'erreur est classiquement défini par :

- une longueur $n$, correspondant aux données en sortie du codeur (mot de code de longueur $n$ formé de $k$ données source et de $(n - k)$ données de redondance),
- un nombre de bits ou de symboles d'information utiles $k$, correspondant aux données en entrée du codeur, encore appelées données source, et
- une distance minimale $d_{min}$.

La distance minimale d'un code $d_{min}$ correspond au minimum de distance entre deux mots de code. Elle permet de déterminer le nombre maximum d'erreurs que le code peut corriger dans un mot de code.

Ainsi, plus la distance minimale $d_{min}$ est grande, meilleur est le code correcteur d'erreurs, puisqu'il permet de détecter ($d_{min}$ - 1) symboles erronés et d'en corriger $\lfloor (d_{min} - 1) / 2 \rfloor$ (où l'opérateur $\lfloor \rfloor$ désigne la partie entière).

Parmi ces techniques de codage permettant la correction d'erreurs de transmission, les turbo-codes et les codes LDPC (en anglais « Low-Density Parity Check ») présentent de très bonnes performances en termes de correction d'erreurs pour des codes de grande longueur $n$, avec $n$ de l'ordre de quelques milliers de bits au moins ($n > 1000$).

En revanche, les turbo-codes et les codes LDPC présentent des performances plus faibles pour des codes de plus petite longueur $n$ ($n < 1000$).

Ceci est en partie dû au fait que l'algorithme de propagation de probabilités utilisé au décodage (en anglais « Belief Propagation »), ou ses variantes, devient sous-optimal au fur et à mesure que la longueur minimale des cycles diminue. On rappelle qu'un cycle correspond à un chemin fermé dans un graphe de Tanner représentant les contraintes que doivent remplir les symboles d'un mot pour être un mot du code. La notion de graphe de Tanner est bien connue, et notamment décrite dans l'article « *Minimum-distance bounds by graph analysis* » de R.M. Tanner, « IEEE Transactions on information theory », vol. 47, février 2001.

Un tel algorithme de propagation de probabilités n'est donc pas efficace pour des codes ayant des matrices génératrices très denses (i.e. ayant beaucoup de bits à 1) et donc pour des codes ayant d'excellentes distances de Hamming minimum relatives $\delta = d_{min} / n$.

Par ailleurs, l'algorithme rigoureusement optimal de décodage exhaustif est difficile à réaliser car il est de complexité exponentielle en $O(2^k)$, où k est la dimension du code, et donc très coûteux. De plus, il ne permet dans pas de décoder en temps réel les codes de petite longueur.

De plus, pour un usage industriel, l'optimisation des codes correcteurs d'erreurs comprend la minimisation des complexités de codage et de décodage en termes de coûts de matériel et d'énergie consommée. Or ces problèmes d'optimisation du décodage des codes correcteurs d'erreurs sont encore plus difficiles à résoudre quand les longueurs des codes sont petites à moyennes, c'est-à-dire de l'ordre de $n < 1000$.

Il existe donc un besoin pour une nouvelle technique de décodage des bons codes correcteurs d'erreurs notamment, c'est-à-dire des codes correcteurs d'erreurs présentant une distance minimale $d_{min}$ la plus grande possible, et présentant notamment des cycles très courts. Les publications suivantes sont également à noter.

La publication de Thorsten Hehn et al: "Multiple-bases belief-propagation decoding of high-density cyclic codes", IEEE Transactions on Communications, janvier 2010, pages 1-8, divulgue le concept de décodage par propagation de croyance à base multiple (Multiple Base Belief Propagation, MBBP) utilisé pour décoder des codes en block ayant des matrices de parité à haute densité. Selon l'algorithme de décodage MBBP, un ensemble de décodeurs opèrent en parallèle, échangeant une information extrinsèque sur les variable source après certaines des itérations.

La publication de Patrick Adde et al: "Near maximum likelihood soft-decision decoding of a particular class of rate-1/2 systematic linear block codes", Electronics Letters, vol. 47, no. 4, 17 février 2011, pages 259-260, divulgue un procédé de décodage de codes de taux 1/2 incluant les codes de Golay et les codes Cortex, incluant une étape de recodage des variables systématiques utilisant la matrice génératrice $G_s=[I_k,P]$ et une étape de recodage des variables de parité utilisant la matrice génératrice $Gp=[P^{-1},I_k]$.

## 3. Exposé de l'invention

L'invention propose une solution nouvelle qui ne présente pas l'ensemble de ces inconvénients de l'art antérieur, sous la forme d'un procédé de décodage de données codées, comprenant des données source et des données de redondance. Ces données de redondance sont obtenues en appliquant, au codage, un code correcteur d'erreurs aux données source, mettant en oeuvre une matrice génératrice comprenant, sous sa forme systématique, une matrice identité et une matrice de passage des données source aux données de redondance P inversible.

Selon l'invention, le procédé comprend une étape de décodage mettant simultanément en oeuvre le code correcteur d'erreurs, dit code correcteur d'erreurs primal, et un code dual du code correcteur d'erreurs primal, dit code correcteur d'erreurs dual.

L'invention propose ainsi une nouvelle technique de décodage de données codées à l'aide d'un code correcteur d'erreurs, utilisant en même temps le code correcteur d'erreurs sous sa forme primale et sous sa forme duale.

En particulier, l'utilisation combinée du code correcteur d'erreurs sous ses deux formes primale et duale permet de diminuer le nombre d'itérations mises en oeuvre au décodage, notamment pour un algorithme de type propagation de probabilités (« Belief Propagation »), et donc de décoder en temps réel des codes de petite longueur (n<1000).

Selon l'invention, on considère que la matrice de passage des données source aux données de redondance P est inversible. Aucune autre contrainte n'est imposée sur le code correcteur d'erreurs, et notamment sur la longueur de ce code ou la longueur des cycles. On peut donc considérer que le code correcteur d'erreurs mis en oeuvre est quasi-aléatoire.

L'invention offre ainsi un algorithme de décodage plus simple et plus performant que les techniques de l'art antérieur, notamment pour les codes présentant de petites longueurs et/ou des cycles courts.

Selon un mode de réalisation particulier, l'étape de décodage met en oeuvre un graphe de Tanner modifié, dit graphe primal-dual, obtenu en superposant un graphe de Tanner correspondant au code correcteur d'erreurs primal, dit graphe primal, et un graphe de Tanner correspondant au code correcteur d'erreurs dual, dit graphe dual, la superposition consistant à connecter deux à deux les variables d'entrée du graphe primal aux variables d'entrée du graphe dual correspondant aux mêmes données source, et à connecter deux à deux les variables de sortie du graphe primai aux variables de sortie du graphe dual correspondant aux mêmes données de redondance.

De cette façon, chaque variable d'entrée ou de sortie du graphe primal-dual est connectée à un couple de contraintes comprenant une contrainte de type égalité et une contrainte de type addition modulo 2, définissant un arbre élémentaire. En d'autres termes, la structure de décodage proposée permet d'isoler de petits arbres élémentaires correspondant chacun à une donnée source ou une donnée de redondance.

Du fait de cette structure en arbres élémentaires, le graphe primal-dual obtenu ne présente aucune structure de boucles, qui sont classiquement considérées comme source de dégradation sur le décodage. En d'autres termes, il existe un seul chemin d'une racine à une feuille de l'arbre, donc une seule façon de propager l'information dans le graphe primal-dual. Cette structure permet donc de diminuer les effets des cycles qui posent problème selon l'art antérieur, en utilisant de manière optimale l'information disponible. En d'autres termes, le traitement simultané des variables d'entrée/sortie dans le graphe primal-dual permet de compenser les calculs mis en oeuvre pour propager les variables et donc de diminuer l'influence des cycles sur l'algorithme de décodage.

De plus, la propagation des variables internes se trouve modifiée par rapport à l'algorithme classique de type « Belief Propagation », et permet un décodage facilité des codes présentant une petite longueur. Cette structure en arbres élémentaires permet en effet d'obtenir une moyenne de la propagation a priori de données source dans chaque arbre.

Finalement, la présence d'autant de couples de contraintes (ou d'arbres élémentaires) que de données codées (données source et données de redondance) impose d'utiliser toutes les données disponibles, ce qui accroît les performances du décodage. On dispose également de deux fois plus d'informations au niveau des variables d'entrée et de sortie du graphe primal-dual que selon les techniques de l'art antérieur.

La superposition des graphes du code primal et du code dual permet donc d'améliorer les performances de décodage par rapport aux techniques actuelles, en permettant notamment une convergence plus rapide de l'algorithme de décodage vers un mot de code le plus proche du mot reçu. Elle permet également de compenser la non linéarité liée aux contraintes (égalité, addition modulo 2).

En particulier, chaque variable d'entrée ou de sortie du graphe primal-dual étant connectée à un couple de contraintes comprenant une contrainte de type égalité et une contrainte de type addition modulo 2, le procédé de décodage selon l'invention comprend une étape de détermination d'au moins une variable interne au graphe primal-dual mettant en oeuvre :

- pour une contrainte de type addition modulo 2 :

    o une étape de transformation, du domaine réel vers le domaine complexe, des variables connectées à la contrainte de type addition modulo 2 ;
    o une étape d'addition dans le domaine complexe ;
    o une étape de transformation, du domaine complexe vers le domaine réel, du résultat de l'étape d'addition ;

- pour une contrainte de type égalité :

    o une étape d'addition dans le domaine réel.

On simplifie de cette façon les opérations mises en oeuvre pour propager les variables connectées à une contrainte de type égalité ou de type addition modulo 2, en utilisant des opérateurs de type addition dans le domaine complexe ou dans le domaine réel.

En particulier, les étapes de transformation (du domaine réel vers le domaine complexe ou du domaine complexe vers le domaine réel) mettent en oeuvre une fonction non linéaire NL telle que :

$$\begin{cases} NL\big[x\big] = \log\left[\dfrac{1 - \exp\big[x\big]}{1 + \exp\big[x\big]}\right] & \text{si} \quad x \neq 0 \\ NL\big[x\big] = 0 & \text{si} \quad x = 0 \end{cases}$$

On note que cette fonction non linéaire est égale à sa propre inverse : $NL\,[x] = NL^{-1}\,[x]$.

L'application d'une telle fonction non linéaire permet de réaliser l'équivalent du calcul des probabilités a posteriori en sortie d'une contrainte de type addition modulo 2 (ou exclusif) au moyen d'une simple addition dans le corps des réels et d'une multiplication des signes. On diminue de cette façon la complexité opératoire du décodage.

Selon un mode de réalisation particulier, chaque variable d'entrée ou de sortie du graphe primal-dual étant connectée à un couple de contraintes comprenant une contrainte de type égalité et une contrainte de type addition modulo 2, le procédé de décodage met en oeuvre au moins une itération de décodage, comprenant :

- une phase de propagation avant, consistant à propager les variables internes au graphe primal-dual connectées à une contrainte de type égalité pour mettre à jour les variables internes au graphe primal-dual connectées à une contrainte de type addition modulo 2, et
- une phase de propagation arrière, consistant à propager les variables internes au graphe primal-dual connectées à une contrainte de type addition modulo 2 pour mettre à jour les variables internes au graphe primal-dual connectées à une contrainte de type égalité.

En d'autres termes, une itération de décodage comprend une première phase de propagation des données source dans tous les arbres élémentaires, puis une deuxième phase de propagation des données de redondance dans

4

tous les arbres élémentaires, chaque phase se transmettant les valeurs obtenues en sortie de chaque arbre élémentaire.

Les opérateurs associés à chaque couple de contraintes travaillent donc simultanément.

En particulier, la phase de propagation avant met en oeuvre les sous-étapes suivantes, pour chaque couple de contraintes connecté à une variable d'entrée ou de sortie du graphe primal-dual :

- détermination d'une valeur de vraisemblance avant $v_0^F(t)$ affectée à la variable d'entrée ou de sortie du graphe primal-dual, mettant en oeuvre une addition dans le domaine réel, telle que :

$$v_0^F(t) = \frac{\sum_{i=1}^{d} v_i(t)}{d},$$

- détermination de valeurs de vraisemblance affectées aux variables connectées à la contrainte de type addition modulo 2, après transformation du domaine réel vers le domaine complexe, dites valeurs de vraisemblance avant transformées, telle que :

  o la variable d'entrée ou de sortie du graphe primal-dual après transformation s'exprime sous la forme:

$$w_0^F(t) = NL\left[v_0(0) + v_0^F(t)\right] \text{ et}$$

$$s_0^F(t) = signe\left[v_0(0) + v_0^F(t)\right];$$

  o les variables internes après transformation s'expriment sous la forme :

$$w_l^F(t) = NL\left[v_l'(t)\right] \text{ et } s_l^F(t) = signe\left[v_l'(t)\right] \text{ pour } l \in \{1,...,d\};$$

- mise à jour des valeurs de vraisemblance avant transformées, mettant en oeuvre une addition dans le domaine complexe, telle que :

$$w_l^F(t+1) = w_0^F(t) + \frac{\sum_{i=1,i\neq l}^{d} w_i^F(t)}{d-1} \text{ et } s_l^F(t+1) = \prod_{i=0,i\neq l}^{d} s_i^F(t)$$

- mise à jour des valeurs des variables internes connectées à la contrainte de type addition modulo 2, mettant en oeuvre une transformation du domaine complexe vers le domaine réel des valeurs de vraisemblance avant transformées mises à jour, telle que :

$$v_l'(t+1) = s_l^F(t+1)NL\left[w_l^F(t+1)\right];$$

avec :

- $v_0(0)$ une valeur initiale affectée à la variable d'entrée ou de sortie du graphe primal-dual ;
- $v_i(t)$ les variables internes connectées à la contrainte de type égalité ;
- $v_l'(t)$ les variables internes connectées à la contrainte de type addition modulo 2 ;
- $d$ le degré de contraintes associé à une contrainte du graphe primal-dual ;
- $i \in \{1,...,d\}, l \in \{1,...,d\}$ ;
- $NL[x]$ une fonction non linéaire telle que :

$$\begin{cases} NL[x] = \log\left[\dfrac{1 - \exp[x]}{1 + \exp[x]}\right] & \text{si} \quad x \neq 0 \\[2mm] NL[x] = 0 & \text{si} \quad x = 0 \end{cases}$$

La phase de propagation arrière met quant à elle en oeuvre les sous-étapes suivantes, pour chaque couple de contraintes connecté à une variable d'entrée ou de sortie du graphe primal-dual :

- détermination de valeurs de vraisemblance affectées aux variables connectées à la contrainte de type addition modulo 2, après transformation du domaine réel vers le domaine complexe, dites valeurs de vraisemblance arrière transformées, telle que :

  ○ les variables internes après transformation s'expriment sous la forme :

$$w_l^B(t) = NL\left[v_l'(t)\right] \text{ et } s_l^B(t) = signe\left[v_l'(t)\right], \text{ pour } l \in \{1, ..., d\} ;$$

  ○ la variable d'entrée ou de sortie du graphe primal-dual après transformation s'exprime sous la forme :

$$w_0^B(t) = \frac{\sum_{l=1}^{d} w_l^B(t)}{d} \text{ et } s_0^B(t) = \left(\prod_{l=1}^{d} s_l^B(t)\right) ;$$

- détermination d'une valeur de vraisemblance arrière $v_0^B(t)$ affectée à la variable d'entrée ou de sortie du graphe primal-dual, mettant en oeuvre une transformation du domaine complexe vers le domaine réel de la variable d'entrée ou de sortie après transformation, telle que :

$$v_0^B(t) = s_0^{B(t)} \times NL\left[w_0^B(t)\right]$$

- mise à jour des valeurs des variables internes connectées à la contrainte de type égalité, mettant en oeuvre une addition dans le domaine réel, telle que :

$$v_l(t+1) = v_0(0) + v_0^B(t) + \frac{\sum_{i=1, i \neq l}^{d} v_i(t)}{d - 1},$$

- mise à jour de la variable d'entrée ou de sortie du graphe primal-dual, telle que :

$$v_0(t+1) = v_0^F(t) + v_0(0) + v_0^B(t)$$

Selon une caractéristique particulière de l'invention, le procédé de décodage comprend une étape préalable d'initialisation des variables d'entrée, des variables de sortie, et des variables internes du graphe primal-dual à zéro.

La mise en oeuvre de ces deux phases de propagation avant et arrière selon l'invention, ainsi que l'initialisation de l'ensemble des variables, permet d'obtenir une convergence très rapide de l'algorithme de décodage vers le mot de code le plus proche du mot reçu.

Selon un autre aspect de l'invention, au moins deux variables d'entrée ou de sortie du graphe primal-dual sont connectées à un même couple de contraintes comprenant une contrainte de type égalité et une contrainte de type addition modulo 2.

Il est ainsi possible de multiplexer les opérateurs utilisés pour propager les variables connectées à une contrainte de type égalité ou de type addition modulo 2, et de diminuer ainsi la quantité de ressources matérielles nécessaire.

Selon un mode de réalisation particulier de l'invention, le code correcteur d'erreurs primal présente un rendement égal à ½. En d'autres termes, il s'agit d'un code quasi-aléatoire de paramètres ($n = 2k,k,d_{min}$). On obtient dans ce cas une structure symétrique du graphe primal-dual, permettant de décoder simplement et de façon optimale un tel code de rendement égal à ½.

Bien entendu, il est également possible de décoder des codes correcteurs d'erreurs mettant en oeuvre un rendement différent de ½.

Ainsi, pour décoder un code correcteur d'erreurs présentant un rendement supérieur à ½, on peut ajouter une contrainte égalité (respectivement une contrainte addition modulo 2) en sortie de deux contraintes égalité (respectivement deux contraintes addition modulo 2) connectées à deux (ou plus) données de redondance dans le graphe primal-dual.

Pour décoder un code correcteur d'erreurs présentant un rendement inférieur à ½ on peut ajouter une contrainte égalité (respectivement une contrainte addition modulo 2) en sortie de deux contraintes égalité (respectivement deux contraintes addition modulo 2) connectées à deux (ou plus) données source dans le graphe primal-dual.

Dans un autre mode de réalisation, l'invention concerne un dispositif de décodage de données codées correspondant.

Selon l'invention, un tel dispositif comprend un module de décodage mettant simultanément en oeuvre le code correcteur d'erreurs, dit code correcteur d'erreurs primal, et un code dual du code correcteur d'erreurs primal, dit code correcteur d'erreurs dual.

Un tel dispositif de décodage est notamment adapté à mettre en oeuvre le procédé de décodage décrit précédemment.

Un tel décodeur pourra bien sûr comporter les différentes caractéristiques relatives au procédé de décodage selon l'invention, qui peuvent être combinées ou prises isolément. Ainsi, les caractéristiques et avantages de ce décodeur sont les mêmes que ceux du procédé de décodage, et ne sont donc pas détaillés plus amplement.

On note qu'un tel décodeur peut être implémenté sous la forme d'un circuit intégré, ou dans un composant électronique de type microprocesseur. Ainsi, l'algorithme de décodage selon l'invention peut être mis en oeuvre de diverses manières, notamment sous forme câblée ou sous forme logicielle.

En particulier, il est possible d'utiliser un décodeur tel que décrit ci-dessus soit pour décoder des données codées, soit pour coder des données source. Dans ce dernier cas, on peut forcer à zéro les données de redondance, afin de pouvoir utiliser le décodeur comme un codeur.

L'invention concerne ainsi également un procédé de codage de données source, délivrant des données codées comprenant les données source et des données de redondance.

Selon l'invention, un tel procédé de codage comprend une étape de codage mettant simultanément en oeuvre :

- un code correcteur d'erreurs, dit code correcteur d'erreurs primal, mettant en oeuvre une matrice génératrice comprenant, sous sa forme systématique, une matrice identité et une matrice de passage des données source aux données de redondance P inversible, et
- un code dual du code correcteur d'erreurs primal, dit code correcteur d'erreurs dual.

L'invention propose ainsi une nouvelle technique de codage de données source à l'aide d'un code correcteur d'erreurs utilisant en même temps le code correcteur d'erreurs sous sa forme primale et sous sa forme duale.

Il est ainsi possible d'obtenir simplement de nouveaux codes ou de reconstruire des codes existants, présentant une longueur quelconque, facilement décodables par le procédé de décodage selon l'invention.

Un tel procédé de codage pourra bien sûr comporter les différentes caractéristiques relatives au procédé de décodage selon l'invention.

Dans un autre mode de réalisation, l'invention concerne un dispositif de codage correspondant. Un tel dispositif comprend un module de codage mettant simultanément en oeuvre :

- un code correcteur d'erreurs, dit code correcteur d'erreurs primal, mettant en oeuvre une matrice génératrice comprenant, sous sa forme systématique, une matrice identité et une matrice de passage des données source aux données de redondance P inversible, et
- un code dual du code correcteur d'erreurs primal, dit code correcteur d'erreurs dual.

Un tel dispositif de codage est notamment adapté à mettre en oeuvre le procédé de codage décrit précédemment.

A nouveau, un tel codeur peut être implémenté sous la forme d'un circuit intégré, ou dans un composant électronique de type microprocesseur. Ainsi, l'algorithme de codage selon l'invention peut être mis en oeuvre de diverses manières, notamment sous forme câblée ou sous forme logicielle.

L'invention concerne encore un dispositif de codage et de décodage de données, comprenant un module de codage et de décodage mettant simultanément en oeuvre :

- un code correcteur d'erreurs, dit code correcteur d'erreurs primal, mettant en oeuvre une matrice génératrice comprenant, sous sa forme systématique, une matrice identité et une matrice de passage des données source aux données de redondance P inversible, et
- un code dual du code correcteur d'erreurs primal, dit code correcteur d'erreurs dual.

Un tel dispositif, encore appelé codec pour codeur/décodeur, peut être implémenté sous la forme d'un circuit intégré, ou dans un composant électronique de type microprocesseur. En particulier, l'utilisation d'un codec permet de mutualiser les ressources matérielles utilisées au codage et au décodage. Par exemple, un tel codec peut recevoir en entrée des données source, et délivrer en sortie des données codées, ou recevoir en entrée des données codées, et délivrer en sortie une estimation des données source.

Dans encore un autre mode de réalisation, l'invention concerne un ou plusieurs programmes d'ordinateur comportant des instructions pour la mise en oeuvre d'un procédé de décodage ou d'un procédé de codage tels que décrits précédemment, lorsque le ou les programmes sont exécutés par un processeur. De tels programmes peuvent être stockés sur un support d'information.

## 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- la figure 1 présente les principales étapes mises en oeuvre par un codeur/décodeur selon l'invention ;
- les figures 2A, 2B et 2C illustrent respectivement un graphe de Tanner d'un code de Hamming (8, 4, 4) présentant une matrice de passage P inversible, un graphe de Tanner du code dual du code de Hamming (8, 4, 4), et un graphe primal-dual correspondant selon l'invention ;
- les figures 3A, 3B et 3C illustrent respectivement un graphe de Tanner d'un code (12,6) présentant une matrice de passage P inversible, un graphe de Tanner du code dual de ce code (12,6), et un graphe primal-dual corrspondant selon l'invention ;
- la figure 4 détaille un couple de contraintes selon l'invention ;
- les figures 5A et 5B illustrent la fonction de non linéarité NL utilisée pour déterminer les variables internes à un graphe primal-dual selon l'invention ;
- les figures 6A et 6B présentent les structures simplifiées d'un codeur et d'un décodeur selon un mode de réalisation particulier de l'invention.

## 5. Description d'un mode de réalisation de l'invention

### 5.1 Principe général

Le principe général de l'invention repose sur l'utilisation simultanée d'un code correcteur d'erreurs, dit code primal, et du dual de ce code correcteur d'erreurs, dit code dual, pour coder ou décoder des données.

On considère ici une définition générale de la dualité, encore appelée iso-dualité, telle qu'exprimée notamment dans le document « Handbook of coding theory », V.S. Pless et W.C. Huffman - Volume I - Chapitre 3 - pages 177 à 294. Cette définition n'impose pas de contrainte d'orthogonalité entre les vecteurs du code primal et du code dual. La seule contrainte est l'inversibilité de la matrice de passage des données source aux données de redondance.

L'invention offre notamment une solution au problème du décodage à décision douce des codes en bloc correcteurs d'erreurs de longueur $n$ contenant $k$ données source (encore appelée symboles ou bits d'information). En particulier, elle propose une nouvelle technique de décodage optimal des codes correcteurs d'erreurs présentant de grandes distances minimales pour ces paramètres $n$ et $k$.

A titre d'exemple, l'invention offre une technique de décodage présentant de meilleures performances que les techniques de l'art antérieur vis-à-vis des bons codes correcteurs d'erreurs tels que : les codes algébriques classiques comme le code de Golay (24,12,8), le code (48,24,12), les codes de Reed-Müller (RM) ; les turbo-codes ; les codes LDPC, etc.

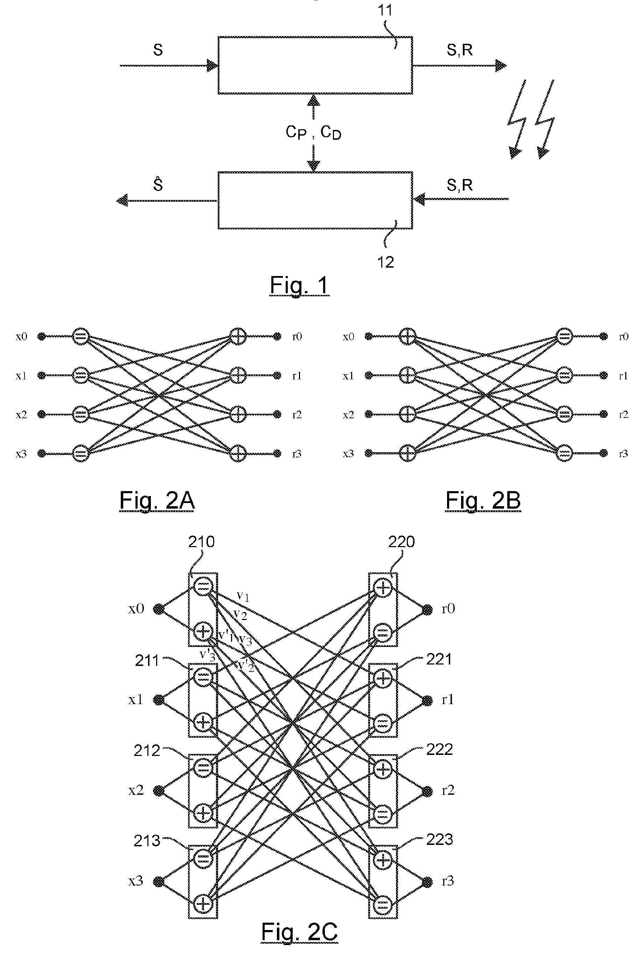

On présente, en relation avec la figure 1, les principales étapes mises en oeuvre par un codeur et/ou un décodeur binaire selon l'invention. Il s'agit ici d'un simple exemple, dans lequel on utilise l'invention à la fois pour le codage et pour le décodage des données. Bien entendu, il est possible d'utiliser l'algorithme de codage proposé avec un algorithme de décodage classique, ou d'utiliser l'algorithme de décodage proposé avec un algorithme de codage classique. Dans ce dernier cas, la seule contrainte imposée au codeur est que la matrice de passage des données source aux données de redondance soit inversible.

Ainsi, selon le mode de réalisation illustré en figure 1, un codeur selon l'invention prend en entrée des données source S, sous la forme de paquets ou d'un flux continu, et délivre en sortie des données codées, comprenant les données source S et des données de redondance R. Ces données codées peuvent être véhiculées dans un canal de transmission ou stockées sur un support, puis décodées par un décodeur selon l'invention.

Un tel décodeur reçoit donc en entrée les données codées, comprenant les données source S et des données de redondance R éventuellement entachées d'erreur, et délivre une estimation des données source $\hat{S}$.

Plus précisément, le codeur met en oeuvre une étape de codage 11 mettant simultanément en oeuvre :

- un code correcteur d'erreurs, dit code correcteur d'erreurs primal CP, mettant en oeuvre une matrice génératrice comprenant, sous sa forme systématique, une matrice identité et une matrice de passage des données source aux données de redondance P inversible, et
- un code dual du code correcteur d'erreurs primal, dit code correcteur d'erreurs dual CD.

De la même façon, le décodeur met en oeuvre une étape de décodage 12 mettant simultanément en oeuvre le code correcteur d'erreurs primal CP et le code correcteur d'erreurs dual CD.

On note que l'étape de codage 11 et l'étape de décodage 12 utilisent toutes les deux à la fois le code correcteur d'erreurs primal CP et le code correcteur d'erreurs dual CD. Le codeur et le décodeur peuvent donc partager des ressources, ce qui permet de diminuer les complexités de codage et de décodage en termes de coûts de matériel et d'énergie consommée.

*5.2 Graphe de Tanner primal-dual*

Selon l'invention, l'étape de codage 11 et/ou l'étape de décodage 12 mettent en oeuvre un graphe de Tanner modifié, dit graphe primal-dual, obtenu en superposant un graphe de Tanner correspondant au code primal CP, dit graphe primal, et un graphe de Tanner correspondant au code dual CD, dit graphe dual.

Le graphe de Tanner correspondant au code dual selon l'invention peut être obtenu de différentes façons.

Selon un premier exemple, le graphe de Tanner dual est construit à partir du graphe de Tanner primal, en remplaçant les contraintes de type égalité par des contraintes de type addition modulo 2, et les contraintes de type addition modulo 2 par des contraintes de type égalité.

Selon un deuxième exemple, le graphe de Tanner dual est directement construit à partir de l'inverse de la matrice de passage des données source aux données de redondance (notée $P^{-1}$). Cette matrice inverse permet en effet d'exprimer les données source à partir des données de redondance.

On décrit ci-après deux exemples de construction de tels graphes primal-dual, pour un code de Hamming étendu (8, 4, 4) et pour un code (12,6) présentant une matrice de passage des données source aux données de redondance P inversible. Ces deux codes présentent un rendement égal à ½, mais comme déjà indiqué, il est également possible de décoder des codes mettant en oeuvre un rendement supérieur à ½ ou inférieur à ½, respectivement en :

- ajoutant une contrainte égalité (respectivement une contrainte addition modulo 2) en sortie de deux contraintes égalité (respectivement deux contraintes addition modulo 2) connectées à deux (ou plus) données de redondance dans le graphe primal-dual, ce qui revient à considérer un code correcteur d'erreurs de départ quasi-aléatoire de matrice de passage P inversible et à ajouter des colonnes à la matrice de passage P ;
- ajoutant une contrainte égalité (respectivement une contrainte addition modulo 2) en sortie de deux contraintes égalité (respectivement deux contraintes addition modulo 2) connectées à deux (ou plus) données source dans le graphe primal-dual, ce qui revient à considérer un code correcteur d'erreurs de départ quasi-aléatoire de matrice de passage P inversible et à ajouter des lignes à la matrice de passage P.

Bien entendu, l'invention peut être utilisée pour décoder d'autres codes, comme le code de Golay, les codes de Reed-Müller, les turbo-codes, les codes LDPC, etc.

*A) Premier exemple: code de Hamming étendu (8, 4, 4)*

On présente ci-après la construction d'un graphe primal-dual, obtenu à partir des graphes primal et dual du code de Hamming étendu ($n = 8, k = 4, d_{min} = 4$).

Un tel code met en oeuvre une matrice génératrice G comprenant, sous sa forme systématique, une matrice identité et une matrice de passage des données source aux données de redondance P inversible, telles que par exemple :

$$G=\begin{bmatrix} Id | P \end{bmatrix} = \begin{bmatrix} 1 & 0 & 0 & 0 & 0 & 1 & 1 & 1 \\ 0 & 1 & 0 & 0 & 1 & 0 & 1 & 1 \\ 0 & 0 & 1 & 0 & 1 & 1 & 0 & 1 \\ 0 & 0 & 0 & 1 & 1 & 1 & 1 & 0 \end{bmatrix}$$

Il s'agit ici d'un cas particulier, selon lequel la matrice de passage P est égale à sa transposée P=P$^{tr}$, et donc PP$^{tr}$ = Id, d'où la matrice de passage P est égale à sa propre inverse P$^{-1}$=P$^{tr}$. Le code de Hamming (8, 4, 4) selon cet exemple est donc auto-dual.

On considère selon cet exemple des données source prenant la forme de quatre bits d'information notés $(x_0, x_1, x_2, x_3)$, et des données de redondance prenant la forme de quatre bits de redondance notés $(r_0, r_1, r_2, r_3)$.

De manière classique, les relations algébriques de calcul des bits de redondance à partir des bits d'information peuvent être représentées par un graphe de Tanner correspondant au code de Hamming (8, 4, 4) primal, tel qu'illustré en figure 2A.

Un tel graphe, dit graphe primal, comprend des variables d'entrée, correspondant aux bits d'information, et des variables de sortie, correspondant aux bits de redondance, les bits de redondance étant liés aux bits d'informations par l'intermédiaire de contraintes et de permutations. Ces contraintes peuvent être de deux types :

- les contraintes de type égalité, représentées par le signe « = », correspondant à une répétition de la variable connectée à cette contrainte ;
- les contraintes de type addition modulo 2, représentées par le signe « + », correspondant à une contrainte logique de type « ou-exclusif ».

En d'autres termes, ces contraintes et permutations permettent de représenter les relations algébriques suivantes :

$$r_0 = x_1 + x_2 + x_3 \ ;$$

$$r_1 = x_0 + x_2 + x_3 \ ;$$

$$r_2 = x_0 + x_1 + x_3$$

et

$$r_3 = x_0 + x_1 + x_2 \ .$$

Comme le code de Hamming (8, 4, 4) est auto-dual, sa matrice de passage P est égale à sa propre inverse, et il suffit de remplacer les contraintes de type égalité par des contraintes de type addition modulo 2, et les contraintes de type addition modulo 2 par des contraintes de type égalité, pour obtenir le graphe de Tanner correspondant au code dual du code de Hamming (8, 4, 4). Les permutations mises en oeuvre sont donc identiques entre les deux graphes primal et dual. Au niveau des ressources matérielles, on utilise donc selon cet exemple deux entrelaceurs identiques.

La figure 2B illustre ainsi le graphe dual obtenu, comprenant des variables d'entrée, correspondant aux bits d'information, et des variables de sortie, correspondant aux bits de redondance.

Selon l'invention, on définit un graphe de Tanner modifié, dit graphe primal-dual, permettant de tenir simultanément compte du code primal et du code dual.

Pour ce faire, on superpose les graphes primal, illustré en figure 2A, et dual, illustré en figure 2B, pour obtenir un graphe primal-dual, illustré en figure 2C.

Cette superposition consiste à connecter deux à deux les variables d'entrée du graphe primal $(x_0, x_1, x_2, x_3)$ aux variables d'entrée du graphe dual $(x_0, x_1, x_2, x_3)$ correspondant aux mêmes données source, et à connecter deux à deux les variables de sortie $(r_0, r_1, r_2, r_3)$ du graphe primal aux variables de sortie $(r_0, r_1, r_2, r_3)$ du graphe dual correspondant aux mêmes données de redondance.

En d'autres termes, on relie les bits d'information $x_i$ du graphe primal aux bits d'information $x_i$ du graphe dual, pour i entier allant de 0 à 3, et on relie les bits de redondance $r_i$ du graphe primal aux bits de redondance $r_i$ du graphe dual, pour i entier allant de 0 à 3.

Chaque variable d'entrée $x_i$ du graphe primal-dual et chaque variable de sortie $r_i$ se trouve donc connectée à un couple de contraintes comprenant une contrainte de type égalité et une contrainte de type addition modulo 2.

Selon l'exemple illustré en figure 2C, on obtient donc huit couples de contraintes, encadrés sur la figure, connectés chacun à :

- une variable d'entrée ou de sortie (de type bit d'information $x_i$ ou bit de redondance $r_i$) et

- six variables internes (notées par exemple $v_1$, $v_2$, $v_3$, $v_1'$, $v_2'$, $v_3'$ pour le couple de contraintes 210, où les variables notées $v_k$ proviennent d'une contrainte de type égalité et les variables notées $v_k'$ proviennent d'une contrainte de type addition modulo 2).

Les quatre couples de contraintes 210, 211, 212, 213 connectés aux variables d'entrée $(x_0,x_1,x_2,x_3)$ sont reliés aux quatre couples de contraintes 220, 221, 222, 223 connectés aux variables de sortie $(r_0,r_1,r_2,r_3)$ par l'intermédiaire de permutations ou entrelaceurs de $4 \times 3 = 12$ couples d'état interne au codeur-décodeur.

Chaque couple de contraintes et ses connexions peut être considéré comme un arbre de la théorie des graphes, c'est-à-dire qui ne présente aucune structure de boucle.

*B) Deuxième exemple : code (12,6)*

On présente ci-après un deuxième exemple de construction d'un graphe primal-dual selon l'invention, obtenu à partir des graphes primal et dual du code (12,6).

On se place ici dans un cas plus général, où la matrice de passage P est simplement inversible.

Un tel code met en oeuvre une matrice génératrice G comprenant, sous sa forme systématique, une matrice identité et une matrice de passage des données source aux données de redondance P inversible, telles que par exemple :

$$G = \begin{bmatrix} Id | P \end{bmatrix} = \begin{bmatrix} 1 & 0 & 0 & 0 & 0 & 0 & | 1 & 0 & 1 & 0 & 0 & 1 \\ 0 & 1 & 0 & 0 & 0 & 0 & | 1 & 0 & 1 & 0 & 1 & 0 \\ 0 & 0 & 1 & 0 & 0 & 0 & | 1 & 1 & 0 & 0 & 0 & 1 \\ 0 & 0 & 0 & 1 & 0 & 0 & | 0 & 1 & 0 & 1 & 0 & 0 \\ 0 & 0 & 0 & 0 & 1 & 0 & | 1 & 0 & 1 & 1 & 0 & 1 \\ 0 & 0 & 0 & 0 & 0 & 1 & | 0 & 0 & 1 & 0 & 1 & 0 \end{bmatrix}$$

On considère selon cet exemple des données source prenant la forme de six bits d'information notés $(x_0,x_1,x_2,x_3,x_4,x_5)$, et des données de redondance prenant la forme de six bits de redondance notés $(r_0,r_1,r_2,r_3,r_4,r_5)$.

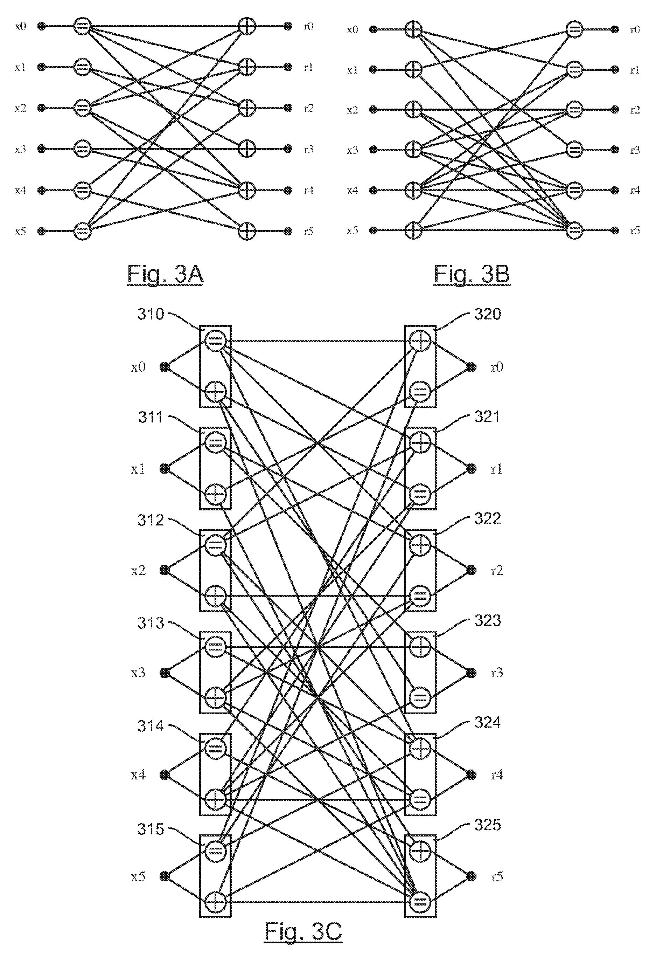

De manière classique, les relations algébriques de calcul des bits de redondance à partir des bits d'information peuvent être représentées par un graphe de Tanner correspondant au code (12,6) primal, tel qu'illustré en figure 3A.

Comme indiqué en relation avec le premier exemple, un tel graphe primal comprend des variables d'entrée, correspondant aux bits d'information, et des variables de sortie, correspondant aux bits de redondance, les bits de redondance étant liés aux bits d'informations par l'intermédiaire de contraintes (de type égalité ou addition modulo 2) et de permutations.

Considérant que la matrice de passage P est inversible, on peut déterminer la matrice de passage inverse $P^{-1}$ et le graphe de Tanner correspondant au dual du code (12,6). La figure 3B illustre ainsi le graphe dual obtenu, comprenant des variables d'entrée, correspondant aux bits d'information, et des variables de sortie, correspondant aux bits de redondance.

On note que comme le code (12,6) n'est pas auto-dual, sa matrice de passage P n'est pas égale à sa propre inverse, et les graphes primal et dual obtenus ne sont pas symétriques. Au niveau des ressources matérielles, on utilise donc selon cet exemple deux entrelaceurs distincts.

Selon l'invention, et comme décrit en relation avec le premier exemple, on définit un graphe de Tanner modifié, dit graphe primal-dual, permettant de tenir simultanément compte du code primal et du code dual. Pour ce faire, on superpose les graphes primal, illustré en figure 3A, et dual, illustré en figure 3B, pour obtenir un graphe primal-dual, illustré en figure 3C.

Cette superposition consiste à connecter deux à deux les variables d'entrée du graphe primal ($x_0,x_1,x_2,x_3,x_4,x_5$) aux variables d'entrée du graphe dual ($x_0,x_1,x_2,x_3,x_4,x_5$) correspondant aux mêmes données source, et à connecter deux à deux les variables de sortie ($r_0,r_1,r_2,r_3,r_4,r_5$) du graphe primal aux variables de sortie ($r_0,r_1,r_2,r_3,r_4,r_5$) du graphe dual correspondant aux mêmes données de redondance.

En d'autres termes, on relie les bits d'information $x_i$ du graphe primal aux bits d'information $x_i$ du graphe dual, pour i entier allant de 0 à 5, et on relie les bits de redondance $r_i$ du graphe primal aux bits de redondance $r_i$ du graphe dual, pour i entier allant de 0 à 5. Chaque variable d'entrée $x_i$ du graphe primal-dual et chaque variable de sortie $r_i$ se trouve donc connectée à un couple de contraintes comprenant une contrainte de type égalité et une contrainte de type addition modulo 2.

Selon l'exemple illustré en figure 3C, on obtient donc douze couples de contraintes, encadrés sur la figure, connectés chacun à :

- une variable d'entrée ou de sortie (de type bit d'information $x_i$ ou bit de redondance $r_i$) ; et
- un ensemble de variables internes.

Les six couples de contraintes 310, 311, 312, 313, 314, 315 connectés aux variables d'entrée ($x_0,x_1,x_2,x_3,x_4,x_5$) sont reliés aux six couples de contraintes 320, 321, 322, 323, 324, 325 connectés aux variables de sortie ($r_0,r_1,r_2,r_3,r_4,r_5$) par l'intermédiaire de permutations ou entralaceurs. A nouveau, chaque couple de contraintes et ses connexions peut être considéré comme un arbre de la théorie des graphes, qui ne présente aucune structure de boucle.

*5.3 Détermination des variables connectées à des contraintes de type égalité ou addition modulo 2*

On décrit ci-après les étapes mises en oeuvre pour la détermination des variables internes à un graphe primal-dual, associées à un couple de contraintes, selon un aspect particulier de l'invention. Bien entendu, d'autres techniques, et notamment des techniques classiques, peuvent être utilisées pour déterminer ces variables internes.

On considère que les variables d'entrée ou de sortie connectées à un couple de contraintes, notées $v_i(0)$ à l'instant initial $t = 0$, sont homogènes à des logarithmes de rapport de vraisemblance, classiquement définis par :

$$v_i(0) = \log\left[\frac{proba\left(y_i \mid c_i = 1\right)}{proba\left(y_i \mid c_i = 0\right)}\right]$$

Les variables internes sont donc aussi homogènes à des logarithmes de rapport de vraisemblance.

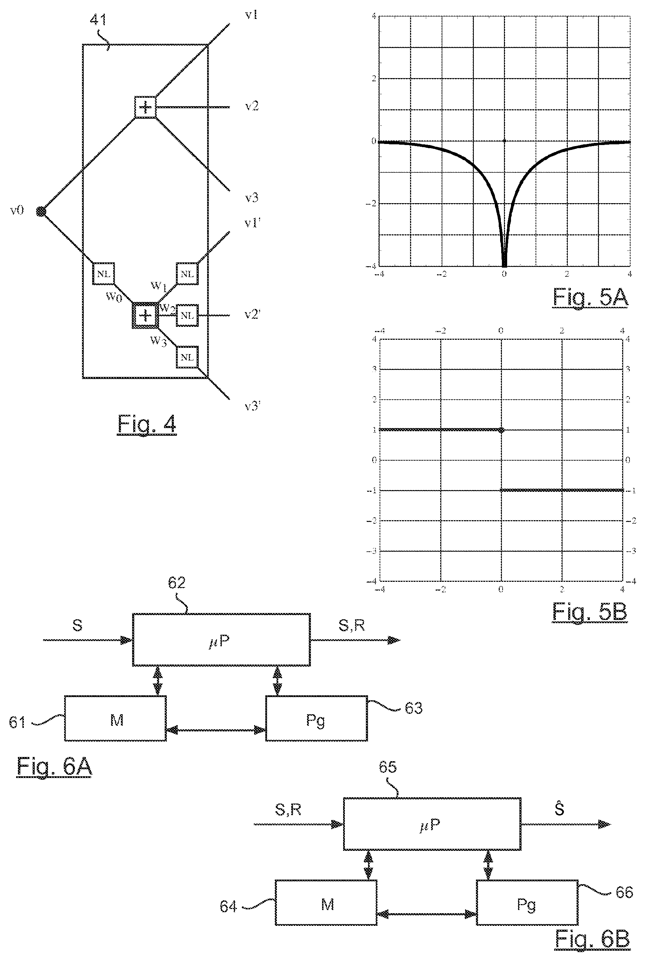

On considère également, à titre d'exemple, un couple de contraintes du graphe primal-dual du code de Hamming (8, 4, 4), connecté d'une part à une variable d'entrée ou de sortie (de type bit d'information $x_i$ ou bit de redondance $r_i$, noté plus généralement $v_i$) et d'autre part à six variables internes. Un tel exemple de couple de contraintes est illustré en figure 4.

Pour effectuer la fusion des variables connectées à une contrainte de type égalité d'un couple de contraintes 41 (fusion des variables d'entrée ou de sortie à l'instant initial et des variables internes), on peut ajouter à la variable d'entrée ou de sortie à l'instant initial la moyenne des valeurs des variables internes connectées à cette contrainte.

Ainsi, si l'on considère une variable d'entrée ou de sortie $v_0$ du couple de contraintes 41 à l'instant initial $t = 0$, la nouvelle valeur de cette variable à l'instant suivant $t = 1$ (c'est-à-dire à l'itération suivante) peut s'exprimer sous la forme suivante :

$$v_0(1) = v_0(0) + \frac{\left(v_1(0) + v_2(0) + v_3(0)\right)}{3}$$

On effectue donc une addition dans le domaine réel pour déterminer les valeurs des variables connectées à une contrainte de type égalité

Pour effectuer la fusion des variables connectées à une contrainte de type addition modulo 2 d'un couple de contraintes 41 (fusion des variables d'entrée ou de sortie à l'instant initial et des variables internes), on propose selon un aspect particulier de l'invention de travailler dans le domaine complexe plutôt que dans le domaine réel, afin de pouvoir utiliser une simple opération d'addition.

Ainsi, selon cet aspect de l'invention, on applique une fonction non-linéaire $NL[x]$ à toutes les variables connectées à une contrainte de type addition modulo 2, avant de pouvoir les additionner, dans le domaine complexe.

Plus précisément, on applique la fonction NL à la variable d'entrée ou de sortie $v_0$ du couple de contraintes 41 à l'instant $t = 0$, dans le domaine réel, pour obtenir une variable interne dans le domaine complexe notée $w_0$, et la fonction NL aux trois variables internes $v_1', v_2', v_3'$ dans le domaine réel, pour obtenir trois variables internes $w_1$, $w_2$, $w_3$ dans le domaine complexe.

On repasse ensuite dans le domaine réel pour obtenir la nouvelle valeur de la variable $v_0$ à l'instant suivant $t = 1$. Ainsi, on obtient :

$$v_0(1) = NL\left[ NL\left[ v_0(0) \right] + \frac{\left( NL\left[ v_1'(0) \right] + NL\left[ v_2'(0) \right] + NL\left[ v_3'(0) \right] \right)}{3} \right] = NL\left[ w_0 + \frac{\left( w_1 + w_2 + w_3 \right)}{3} \right]$$

On effectue donc une transformation du domaine réel vers le domaine complexe des variables connectées à la contrainte de type addition modulo 2, une addition dans le domaine complexe, puis une transformation du domaine complexe vers le domaine réel du résultat de l'addition, pour déterminer les valeurs des variables connectées à une contrainte de type addition modulo 2.

En particulier, la fonction non-linéaire NL peut s'exprimer sous la forme suivante :

$$\begin{cases} NL\left[ x \right] = \log\left[ \dfrac{1 - \exp\left[ x \right]}{1 + \exp\left[ x \right]} \right] & si \quad x \neq 0 \\ NL\left[ x \right] = 0 & si \quad x = 0 \end{cases}$$

Les figures 5A et 5B illustrent respectivement la partie réelle de la fonction NL $\left( \Re\left[ NL\left[ x \right] \right] \right)$ et la variation du signe de la partie imaginaire de la fonction $NL \left( e^{\Im\left[ NL\left[ x \right] \right]} \right)$.

Plus précisément, étant donné le domaine de variation de $x \in ]-\infty,+\infty[$, le résultat de l'application de la fonction non-linéaire NL est rigoureusement à valeurs dans le corps des nombres complexes C, avec une partie imaginaire pouvant prendre deux valeurs $\{0,+I\pi\}$, où $I$ est le nombre imaginaire pur. De plus, aux fins d'initialisation, on impose $NL[0] = 0$.

Pour simplifier les calculs, il est alors possible de considérer cette partie imaginaire pure comme un signe, et de multiplier simplement le résultat de l'addition des parties réelles par le produit des signes. Cette addition dans le « domaine dual » est donc équivalente à une addition dans le corps des complexes $\mathbb{C}$, ce qui est particulièrement astucieux et novateur, notamment pour les décodeurs à décision douce.

Cette fonction non-linéaire NL peut être réalisée avec des nombres quantifiés de façon très peu complexe avec une mémoire programmable par exemple, comme une EPROM (en anglais « Erasable Programmable Read-Only Memory »), également appelée LUT (en anglais « Look-Up Table »).

Bien entendu, des opérations similaires peuvent être mises en oeuvre pour déterminer les valeurs des variables connectées à une contrainte de type égalité ou à une contrainte de type addition modulo 2 dans d'autres contextes, et notamment pour déterminer les valeurs des variables non connectées à un couple de contraintes. De même, des opérations similaires peuvent être mises quelque soit le nombre de variables internes connectées à la contrainte, en adaptant les équations ci-dessus.

*5.4 Propagation des variables*

On présente ci-après les différentes étapes mises en oeuvre pour décoder des données codées reçues, en utilisant simultanément un code correcteur d'erreurs primal et son dual.

On considère pour construire un tel décodeur les graphes primal-dual tels que définis précédemment, et notamment les exemples illustrés en figures 2C et 3C.

Plus précisément, l'algorithme de décodage met en oeuvre au moins une itération de décodage, comprenant :

- une phase de propagation avant, consistant à propager les variables internes au graphe primal-dual connectées à une contrainte de type égalité pour mettre à jour les variables internes au graphe primal-dual connectées à une contrainte de type addition modulo 2, et
- une phase de propagation arrière, consistant à propager les variables internes au graphe primal-dual connectées à une contrainte de type addition modulo 2 pour mettre à jour les variables internes au graphe primal-dual connectées à une contrainte de type égalité.

Une itération met en oeuvre les deux phases de propagation avant et arrière pour chaque couple de contraintes (soit huit couples pour le code de Hamming (8, 4, 4), douze couples pour le code (12,6), vingt-quatre couples pour un code de Golay (24, 12, 8), etc).

A l'initialisation, les variables d'entrée, de sortie, et internes au graphe primal-dual sont mises à zéro. Chaque arbre reçoit alors, généralement en provenance d'un démodulateur, des données codées, correspondant soit à une donnée source (bit d'information) soit à une donnée de redondance (bit de redondance).

On décrit ci-après les phases de propagation avant et arrière mises en oeuvre pour chaque arbre élémentaire associé à un couple de contraintes, au cours d'une même itération.

On note $v_0(0)$ la valeur initiale affectée à une variable d'entrée ou de sortie du graphe primal-dual connectée à un couple de contraintes considéré.

La phase de propagation avant, encore appelée « forward propagation », consiste à propager les vraisemblances $v_i(t)$ du domaine primal pour calculer les vraisemblances $v_i'(t+1)$ du domaine dual, où $t$ est l'indice de temps discret, correspondant encore au numéro de l'itération en cours.

Plus précisément, au cours d'une première étape, on détermine une valeur de vraisemblance avant $v_0^F(t)$ affectée à la variable d'entrée ou de sortie connectée à la contrainte considérée, mettant en oeuvre une addition dans le domaine réel, telle que $v_0^F(t) = \dfrac{\sum_{i=1}^{d} v_i(t)}{d}$, avec $i \in \{1,..., d\}$, $d$ le degré de contraintes associé à la contrainte égalité du couple de contraintes considéré, et $v_i(t)$ les variables internes connectées à la contrainte égalité du couple de contraintes considéré.

Au cours d'une deuxième étape, on détermine les valeurs de vraisemblance affectées aux variables connectées à la contrainte de type addition modulo 2, après transformation du domaine réel vers le domaine complexe, dites valeurs de vraisemblance avant transformées, en appliquant la fonction de non linéarité NL comme détaillé au paragraphe ci-dessus.

Ainsi, la variable d'entrée ou de sortie du couple de contraintes considéré, après transformation, s'exprime sous la forme $w_0^F(t) = NL\left[ v_0(0) + v_0^F(t) \right]$ et $s_0^F(t) = signe\left[ v_0(0) + v_0^F(t) \right]$, et les variables internes, après transformation, s'expriment sous la forme $w_l^F(t) = NL\left[ v_l'(t) \right]$ et $s_l^F(t) = signe\left[ v_l'(t) \right]$, avec $l \in \{1,..., d\}$, $d$ le degré de contraintes associé à la contrainte addition modulo 2 du couple de contraintes considéré, et $v_l'(t)$ les variables associé à la contrainte addition modulo 2 du couple de contraintes considéré, et $v_l'(t)$ les variables internes connectées à la contrainte addition modulo 2 du couple de contraintes considéré.

On peut remarquer que les valeurs $w_l^F(t)$ correspondent aux parties réelles de nombres complexes dont les parties imaginaires peuvent prendre les valeurs $\{0,+l\pi\}$, mais en prenant l'exponentielle de ces valeurs, on obtient des valeurs de signe $s_l^F(t) \in \{+1, -1\}$, ce qui permet de simplifier les calculs.

Au cours d'une troisième étape, on détermine les nouvelles valeurs $w_l^F(t+1)$ et $s_l^F(t+1)$ en mettant à jour les valeurs de vraisemblance avant transformées, à partir d'une addition dans le domaine complexe, telle que :

$$w_l^F(t+1) = w_0^F(t) + \dfrac{\sum_{i=1, i \neq l}^{d} w_i^F(t)}{d-1} \text{ et } s_l^F(t+1) = \prod_{i=0, i \neq l}^{d} s_i^F(t).$$

Au cours d'une quatrième étape, on applique de nouveau la fonction de non linéarité NL, afin de mettre à jour les valeurs des variables internes connectées à la contrainte de type addition modulo 2 $v_l'(t+1)$, à partir d'une transformation du domaine complexe vers le domaine réel des valeurs de vraisemblance avant transformées mises à jour, telle que

$$v_l'(t+1) = s_l^F(t+1) NL\left[ w_l^F(t+1) \right]$$

La phase de propagation arrière, encore appelée « backward propagation », consiste quant à elle à propager les vraisemblances $v_l'(t)$ du domaine dual pour calculer les vraisemblances $v_l(t+1)$ du domaine primal.

Plus précisément, au cours d'une première étape, on détermine les valeurs de vraisemblance affectées aux variables connectées à la contrainte de type addition modulo 2 du couple de contrainte considéré, après transformation du domaine réel vers le domaine complexe, dites valeurs de vraisemblance arrière transformées, en appliquant la fonction de non linéarité NL comme détaillé au paragraphe ci-dessus.

Les variables internes après transformation s'expriment alors sous la forme : $w_l^B(t) = NL\left[ v_l'(t) \right]$ et $s_l^B(t) = signe\left[ v_l'(t) \right]$, pour $l \in \{1,..., d\}$, avec $d$ le degré de contraintes associé à la contrainte addition modulo 2 du couple de contraintes considéré.

La variable d'entrée ou de sortie du couple de contraintes considéré après transformation s'exprime quant à elle sous la forme : $w_0^B(t) = \dfrac{\sum_{l=1}^{d} w_l^B(t)}{d}$ et $s_0^B(t) = \left( \prod_{l=1}^{d} s_l^B(t) \right)$.

Au cours d'une deuxième étape, on détermine une valeur de vraisemblance arrière $v_0^B(t)$ affectée à la variable d'entrée ou de sortie du couple de contrainte considéré, mettant en oeuvre une transformation du domaine complexe vers le domaine réel de la variable d'entrée ou de sortie après transformation, en appliquant à nouveau la fonction de non linéarité NL

$$v_0^B(t) = s_0^{B(t)} \times NL\left[ w_0^B(t) \right]$$

Au cours d'une troisième étape, on détermine les valeurs $v_l(t+1)$ en mettant à jour les valeurs des variables internes connectées à la contrainte de type égalité, à partir d'une addition dans le domaine réel, telle que :

$$v_l(t+1) = v_0(0) + v_0^B(t) + \frac{\sum_{i=1, i \neq l}^{d} v_i(t)}{d-1},$$ pour $l \in \{1,..., d\}$, avec $d$ le degré de contraintes associé à la contrainte égalité du couple de contraintes considéré.

Finalement, au cours d'une quatrième étape, on met à jour la variable d'entrée ou de sortie du couple de contraintes considéré : $v_0(t+1) = v_0^F(t) + v_0(0) + v_0^B(t)$.

Comme déjà indiqué, ces deux phases de propagation avant et arrière sont mises en oeuvre pour chaque couple de contraintes au sein d'une itération de décodage.

Plusieurs itérations de décodage peuvent être mises en oeuvre, jusqu'à atteindre un nombre prédéfini d'itérations ou une convergence des variables internes par exemple.

Plus précisément, une fois qu'on a effectué ces calculs pour les couples de contraintes connectés à une variable d'entrée du graphe primal-dual (c'est-à-dire qu'on a effectué les calculs concernant les arbres connectés aux valeurs initiales des bits d'information pour la première itération), les nouveaux couples de valeurs primales et duales $\left( v_l(t+1), v_l'(t+1) \right)$ sont transmis aux couples de contraintes connectés à une variable de sortie du graphe primal-dual (c'est-à-dire aux arbres connectés aux valeurs initiales des bits de redondance pour la première itération) au cours de la phase de propagation avant. Ceci permet d'effectuer un nouvel ensemble de calculs sur ces arbres en notant l'inversion de côté des contraintes de type égalité et addition modulo 2, ce qui revient à permuter les valeurs duales et primales telles que $\left( v_l'(t+1), v_l(t+1) \right)$ au cours de la phase de propagation arrière.

L'algorithme de décodage proposé converge vers le mot de code le plus proche du mot reçu très rapidement (en quelques itérations), quelque soit la longueur du code. Par exemple, alors que selon l'art antérieur parfois 20 à 50 itérations étaient nécessaires pour obtenir une convergence de l'algorithme de décodage d'un code LDPC, l'invention permet d'obtenir une convergence rapide, en seulement quelques itérations (de l'ordre de 5 ou 6 itérations par exemple).

Des saturations à des valeurs suffisamment grandes comme $\pm4$, limitant les valeurs possibles en sortie à l'intervalle [-4,+4], permettent donc de rendre stable et robuste l'algorithme. L'algorithme converge vers ces valeurs de saturation.

A nouveau, on note qu'il est possible d'utiliser la technique de décodage décrite comme nouvelle technique de codage, en forçant à zéro les bits de redondance. Ainsi, considérant un graphe primal-dual définit selon l'invention, comprenant des variables d'entrée correspondant aux données source et des variables de sortie correspondant à des données nulles, on obtient après mises en oeuvre d'au moins une itération des phases de propagation avant et arrière décrites ci-dessus des données de redondance au niveau des variables de sortie.

### 5.5 Structure des codeurs et décodeurs

On présente finalement, en relation avec les figures 6A et 6B, les structures simplifiées d'un codeur et d'un décodeur selon un mode de réalisation particulier de l'invention.

Le codeur comprend une mémoire 61 comprenant une mémoire tampon, une unité de traitement 62, équipée par exemple d'un microprocesseur $\mu$P, et pilotée par le programme d'ordinateur 63, mettant en oeuvre le procédé de codage selon un mode de réalisation de l'invention.

A l'initialisation, les instructions de code du programme d'ordinateur 63 sont par exemple chargées dans une mémoire RAM avant d'être exécutées par le processeur de l'unité de traitement 62. L'unité de traitement 62 reçoit en entrée des données source S et délivre des données codées comprenant les données source et de données de redondance. Le microprocesseur de l'unité de traitement 62 met en oeuvre les étapes du procédé de codage décrit précédemment, selon les instructions du programme d'ordinateur 63, pour coder les données source. Pour cela, le codeur comprend, outre la mémoire tampon 61, un module de codage mettant simultanément en oeuvre un code correcteur d'erreur et son code dual. Ce module est piloté par le microprocesseur de l'unité de traitement 62.

Le décodeur comprend une mémoire 64 comprenant une mémoire tampon, une unité de traitement 65, équipée par exemple d'un microprocesseur $\mu$P, et pilotée par le programme d'ordinateur 66, mettant en oeuvre le procédé de décodage selon un mode de réalisation de l'invention.

A l'initialisation, les instructions de code du programme d'ordinateur 66 sont par exemple chargées dans une mémoire RAM avant d'être exécutées par le processeur de l'unité de traitement 65. L'unité de traitement 65 reçoit en entrée des données codées comprenant des données source et de données de redondance, et délivre une estimation des données source $\hat{S}$. Le microprocesseur de l'unité de traitement 65 met en oeuvre les étapes du procédé de décodage décrit précédemment, selon les instructions du programme d'ordinateur 66, pour décoder les données codées. Pour cela, le décodeur comprend, outre la mémoire tampon 64, un module de décodage mettant simultanément en oeuvre un code correcteur d'erreur et son code dual. Ce module est piloté par le microprocesseur de l'unité de traitement 65.

## Revendications

1. Procédé de décodage de données codées, comprenant des données source (S) et des données de redondance (R), lesdites données de redondance (R) étant obtenues en appliquant, au codage, un code correcteur d'erreurs auxdites données source (S), susceptible d'être représenté par une matrice génératrice comprenant, sous sa forme systématique, une matrice identité et une matrice de passage des données source aux données de redondance (P) inversible,
caractérisé en ce que ledit procédé comprend une étape de décodage (12) mettant simultanément en oeuvre ledit code correcteur d'erreurs, dit code correcteur d'erreurs primal, et un code dual dudit code correcteur d'erreurs primal, dit code correcteur d'erreurs dual , un code dual étant défini comme le code ayant une matrice de passage ($P^{-1}$) inverse de celle (P) du code correcteur d'erreurs primal et qui permet d'exprimer les données source du code correcteur d'erreurs primal à partir de ses données de redondance, cette définition du code dual n'imposant pas de contrainte d'orthogonalité entre les vecteurs du code primal et du code dual, le décodage étant réalisé en utilisant un graphe de Tanner modifié, dit graphe primal-dual, obtenu en superposant un graphe de Tanner correspondant audit code correcteur d'erreurs primal, dit graphe primal, et un graphe de Tanner correspondant audit code correcteur d'erreurs dual, dit graphe dual,

ladite superposition consistant à connecter deux à deux les variables d'entrée ($x0$,...,$x5$) dudit graphe primal aux variables d'entrée ($x0$,...,$x5$) dudit graphe dual correspondant aux mêmes données source, et à connecter deux à deux les variables de sortie ($r0$,...,$r5$) dudit graphe primal aux variables de sortie ($r0$,...,$r5$) dudit graphe dual correspondant aux mêmes données de redondance.

**2.** Procédé de décodage selon la revendication 1, **caractérisé en ce que** chaque variable d'entrée ou de sortie du graphe primal-dual est connectée à un couple de contraintes comprenant une contrainte de type égalité et une contrainte de type addition modulo 2,

et **en ce que** ledit procédé comprend une étape de détermination d'au moins une variable interne audit graphe primal-dual mettant en oeuvre :

- pour une contrainte de type addition modulo 2 :

  ◦ une étape de transformation, du domaine réel vers le domaine complexe, des variables connectées à ladite contrainte de type addition modulo 2 ;
  ◦ une étape d'addition dans le domaine complexe ;
  ◦ une étape de transformation, du domaine complexe vers le domaine réel, du résultat de ladite étape d'addition ;

- pour une contrainte de type égalité :

  ◦ une étape d'addition dans le domaine réel.

**3.** Procédé de décodage selon la revendication 2, **caractérisé en ce que** lesdites étapes de transformation mettent en oeuvre une fonction non linéaire NL telle que :

$$\begin{cases} NL\big[x\big] = \log\left[\dfrac{1-\exp\big[x\big]}{1+\exp\big[x\big]}\right] & si \quad x \neq 0 \\ NL\big[x\big] = 0 & si \quad x = 0 \end{cases}$$

**4.** Procédé de décodage selon la revendication 1, **caractérisé en ce que** chaque variable d'entrée ou de sortie du graphe primal-dual est connectée à un couple de contraintes comprenant une contrainte de type égalité et une contrainte de type addition modulo 2,

et **en ce que** ledit procédé met en oeuvre au moins une itération de décodage, comprenant :

- une phase de propagation avant, consistant à propager les variables internes au graphe primal-dual connectées à une contrainte de type égalité pour mettre à jour les variables internes au graphe primal-dual connectées à une contrainte de type addition modulo 2, et
- une phase de propagation arrière, consistant à propager les variables internes au graphe primal-dual connectées à une contrainte de type addition modulo 2 pour mettre à jour les variables internes au graphe primal-dual connectées à une contrainte de type égalité.

**5.** Procédé de décodage selon la revendication 4, **caractérisé en ce que** ladite phase de propagation avant met en oeuvre les sous-étapes suivantes, pour chaque couple de contraintes connecté à une variable d'entrée ou de sortie du graphe primal-dual :

- détermination d'une valeur de vraisemblance avant $v_0^F(t)$ affectée à ladite variable d'entrée ou de sortie du graphe primal-dual, mettant en oeuvre une addition dans le domaine réel, telle que :

$$v_0^F(t) = \frac{\sum_{i=1}^{d} v_i(t)}{d},$$

- détermination de valeurs de vraisemblance affectées aux variables connectées à la contrainte de type addition modulo 2, après transformation du domaine réel vers le domaine complexe, dites valeurs de vraisemblance avant transformées, telle que :

o ladite variable d'entrée ou de sortie du graphe primal-dual après transformation s'exprime sous la forme:

$$w_0^F(t) = NL\left[ v_0(0) + v_0^F(t) \right] \text{ et}$$

$$s_0^F(t) = signe\left[ v_0(0) + v_0^F(t) \right] ;$$

∘ les variables internes après transformation s'expriment sous la forme :

$$w_l^F(t) = NL\left[ v_l^{'}(t) \right] \text{ et } s_l^F(t) = signe\left[ v_l^{'}(t) \right] \text{ pour } l \in \{1,...,d\} ;$$

- mise à jour des valeurs de vraisemblance avant transformées, mettant en oeuvre une addition dans le domaine complexe, telle que :

$$w_l^F(t+1) = w_0^F(t) + \frac{\sum_{i=1,i\neq l}^{d} w_i^F(t)}{d-1} \text{ et } s_l^F(t+1) = \prod_{i=0,i\neq l}^{d} s_i^F(t)$$

- mise à jour des valeurs des variables internes connectées à la contrainte de type addition modulo 2, mettant en oeuvre une transformation du domaine complexe vers le domaine réel des valeurs de vraisemblance avant transformées mises à jour, telle que :

$$v_l^{'}(t+1) = s_l^F(t+1)NL\left[ w_l^F(t+1) \right] ;$$

avec :
- $v_0(0)$ une valeur initiale affectée à ladite variable d'entrée ou de sortie du graphe primal-dual ;
- $v_i(t)$ les variables internes connectées à la contrainte de type égalité ;
- $v_l^{'}(t)$ les variables internes connectées à la contrainte de type addition modulo 2 ;
- $d$ le degré de contraintes associé à une contrainte du graphe primal-dual ;
- $i \in \{1,...,d\}, l \in \{1,...,d\}$ ;
- $NL[x]$ une fonction non linéaire telle que :

$$\begin{cases} NL[x] = \log\left[ \dfrac{1 - \exp[x]}{1 + \exp[x]} \right] & si \quad x \neq 0 \\ NL[x] = 0 & si \quad x = 0 \end{cases}$$

6. Procédé de décodage selon la revendication 4, **caractérisé en ce que** ladite phase de propagation arrière met en oeuvre les sous-étapes suivantes, pour chaque couple de contraintes connecté à une variable d'entrée ou de sortie du graphe primal-dual :

- détermination de valeurs de vraisemblance affectées aux variables connectées à la contrainte de type addition modulo 2, après transformation du domaine réel vers le domaine complexe, dites valeurs de vraisemblance arrière transformées, telle que :

◦ les variables internes après transformation s'expriment sous la forme :

$$w_l^B(t) = NL\left[v_l^{'}(t)\right] \text{ et } s_l^B(t) = signe\left[v_l^{'}(t)\right], \text{ pour } l \in \{1,...,d\} \; ;$$

◦ ladite variable d'entrée ou de sortie du graphe primal-dual après transformation s'exprime sous la forme :

$$w_0^B(t) = \frac{\sum_{l=1}^{d} w_l^B(t)}{d} \text{ et } s_0^B(t) = \left(\prod_{l=1}^{d} s_l^B(t)\right) \; ;$$

- détermination d'une valeur de vraisemblance arrière $v_0^B(t)$ affectée à ladite variable d'entrée ou de sortie du graphe primal-dual, mettant en oeuvre une transformation du domaine complexe vers le domaine réel de la variable d'entrée ou de sortie après transformation, telle que :

$$v_0^B(t) = s_0^{B(t)} \times NL\left[w_0^B(t)\right]$$

- mise à jour des valeurs des variables internes connectées à la contrainte de type égalité, mettant en oeuvre une addition dans le domaine réel, telle que :

$$v_l(t+1) = v_0(0) + v_0^B(t) + \frac{\sum_{i=1,i\neq l}^{d} v_i(t)}{d-1} \, ,$$

- mise à jour de ladite variable d'entrée ou de sortie du graphe primal-dual, telle que :

$$v_0(t+1) = v_0^F(t) + v_0(0) + v_0^B(t) \; ;$$

avec :
- $v_0(0)$ une valeur initiale affectée à ladite variable d'entrée ou de sortie du graphe primal-dual ;
- $v_l(t)$ les variables internes connectées à la contrainte de type égalité ;
- $v_l(t)$ les variables internes connectées à la contrainte de type addition modulo 2 ;
- $d$ le degré de contraintes associé à une contrainte du graphe primal-dual ;
- $i \in \{1,...,d\}, l \in \{1,...,d\}$ ;
- $NL[x]$ une fonction non linéaire telle que :

$$\begin{cases} NL\left[x\right] = \log\left[\dfrac{1 - \exp\left[x\right]}{1 + \exp\left[x\right]}\right] & si \quad x \neq 0 \\ NL\left[x\right] = 0 & si \quad x = 0 \end{cases}$$

**7.** Procédé de décodage selon la revendication 4, **caractérisé en ce qu'**il comprend une étape préalable d'initialisation des variables d'entrée, des variables de sortie, et des variables internes du graphe primal-dual à zéro.

**8.** Procédé de décodage selon la revendication 1, **caractérisé en ce qu'**au moins deux variables d'entrée ou de sortie du graphe primal-dual sont connectées à un même couple de contraintes comprenant une contrainte de type égalité et une contrainte de type addition modulo 2.

**9.** Dispositif de décodage de données codées, comprenant des données source (S) et des données de redondance (R), lesdites données de redondance (R) étant obtenues en appliquant, au codage, un code correcteur d'erreurs auxdites données source (S), susceptible d'être représenté par une matrice génératrice comprenant, sous sa forme systématique, une matrice identité et une matrice de passage des données source aux données de redondance (P) inversible,

**caractérisé en ce que** ledit dispositif comprend un module de décodage (12) mettant simultanément en oeuvre ledit code correcteur d'erreurs, dit code correcteur d'erreurs primal, et un code dual dudit code correcteur d'erreurs primal, dit code correcteur d'erreurs dual, un code dual étant défini comme le code ayant une matrice de passage ($P^{-1}$) inverse de celle (P) du code correcteur d'erreurs primal et qui permet d'exprimer les données source du code correcteur d'erreurs primal à partir de ses données de redondance, cette définition du code dual n'imposant pas de contrainte d'orthogonalité entre les vecteurs du code primal et du code dual, le décodage étant réalisé en utilisant un graphe de Tanner modifié, dit graphe primal-dual, obtenu en superposant un graphe de Tanner correspondant audit code correcteur d'erreurs primal, dit graphe primal, et un graphe de Tanner correspondant audit code correcteur d'erreurs dual, dit graphe dual,

ladite superposition consistant à connecter deux à deux les variables d'entrée ($x0,...,x5$) dudit graphe primal aux variables d'entrée ($x0,...,x5$) dudit graphe dual correspondant aux mêmes données source, et à connecter deux à deux les variables de sortie ($r0,...,r5$) dudit graphe primal aux variables de sortie ($r0,...,r5$) dudit graphe dual correspondant aux mêmes données de redondance.

10. Procédé de codage de données source (S), délivrant des données codées comprenant lesdites données source (S) et des données de redondance (R),

**caractérisé en ce que** ledit procédé comprend une étape de codage (11) mettant simultanément en oeuvre :

   - un code correcteur d'erreurs, dit code correcteur d'erreurs primal, susceptible d'être représenté par une matrice génératrice comprenant, sous sa forme systématique, une matrice identité et une matrice de passage des données source aux données de redondance (P) inversible, et
   - un code dual dudit code correcteur d'erreurs primal, dit code correcteur d'erreurs dual, un code dual étant défini comme le code ayant une matrice de passage ($P^{-1}$) inverse de celle (P) du code correcteur d'erreurs primal et qui permet d'exprimer les données source du code correcteur d'erreurs primal à partir de ses données de redondance, cette définition du code dual n'imposant pas de contrainte d'orthogonalité entre les vecteurs du code primal et du code dual,

ladite étape de codage mettant en oeuvre un graphe de Tanner modifié, dit graphe primal-dual, obtenu en superposant un graphe de Tanner correspondant audit code correcteur d'erreurs primal, dit graphe primal, et un graphe de Tanner correspondant audit code correcteur d'erreurs dual, dit graphe dual,

ladite superposition consistant à connecter deux à deux les variables d'entrée ($x0,...,x5$) dudit graphe primal aux variables d'entrée ($x0,...,x5$) dudit graphe dual correspondant aux mêmes données source, et à connecter deux à deux les variables de sortie ($r0,...,r5$) dudit graphe primal aux variables de sortie ($r0,...,r5$) dudit graphe dual correspondant aux mêmes données de redondance.

11. Dispositif de codage de données source (S), délivrant des données codées comprenant lesdites données source (S) et des données de redondance (R),

**caractérisé en ce que** ledit dispositif comprend un module de codage (11) mettant simultanément en oeuvre :

   - un code correcteur d'erreurs, dit code correcteur d'erreurs primal, susceptible d'être représenté par une matrice génératrice comprenant, sous sa forme systématique, une matrice identité et une matrice de passage des données source aux données de redondance (P) inversible, et
   - un code dual dudit code correcteur d'erreurs primal, dit code correcteur d'erreurs dual, un code dual étant défini comme le code ayant une matrice de passage ($P^{-1}$) inverse de celle (P) du code correcteur d'erreurs primal et qui permet d'exprimer les données source du code correcteur d'erreurs primal à partir de ses données de redondance, cette définition du code dual n'imposant pas de contrainte d'orthogonalité entre les vecteurs du code primal et du code dual,

ledit module de codage mettant en oeuvre un graphe de Tanner modifié, dit graphe primal-dual, obtenu en superposant un graphe de Tanner correspondant audit code correcteur d'erreurs primal, dit graphe primal, et un graphe de Tanner correspondant audit code correcteur d'erreurs dual, dit graphe dual,

ladite superposition consistant à connecter deux à deux les variables d'entrée ($x0,...,x5$) dudit graphe primal aux variables d'entrée ($x0,...,x5$) dudit graphe dual correspondant aux mêmes données source, et à connecter deux à deux les variables de sortie ($r0,...,r5$) dudit graphe primal aux variables de sortie ($r0,...,r5$) dudit graphe dual correspondant aux mêmes données de redondance.

12. Dispositif de codage et de décodage de données,

**caractérisé en ce qu'**il comprend un module de codage et de décodage mettant simultanément en oeuvre :

- un code correcteur d'erreurs, dit code correcteur d'erreurs primal, susceptible d'être représenté par une matrice génératrice comprenant, sous sa forme systématique, une matrice identité et une matrice de passage des données source aux données de redondance (P) inversible, et
- un code dual dudit code correcteur d'erreurs primal, dit code correcteur d'erreurs dual, un code dual étant défini comme le code ayant une matrice de passage ($P^{-1}$) inverse de celle (P) du code correcteur d'erreurs primal et qui permet d'exprimer les données source du code correcteur d'erreurs primal à partir de ses données de redondance, cette définition du code dual n'imposant pas de contrainte d'orthogonalité entre les vecteurs du code primal et du code dual,

ledit module de codage et de décodage mettant en oeuvre un graphe de Tanner modifié, dit graphe primal-dual, obtenu en superposant un graphe de Tanner correspondant audit code correcteur d'erreurs primal, dit graphe primal, et un graphe de Tanner correspondant audit code correcteur d'erreurs dual, dit graphe dual,

ladite superposition consistant à connecter deux à deux les variables d'entrée ($x0,...,x5$) dudit graphe primal aux variables d'entrée ($x0,...,x5$) dudit graphe dual correspondant aux mêmes données source, et à connecter deux à deux les variables de sortie ($r0,...,r5$) dudit graphe primal aux variables de sortie ($r0,...,r5$) dudit graphe dual correspondant aux mêmes données de redondance.

13. Programme ordinateur comportant des instructions pour la mise en oeuvre d'un procédé de décodage selon la revendication 1 ou d'un procédé de codage selon la revendication 10 lorsque ledit programme est exécuté par un processeur.

**Patentansprüche**

1. Verfahren zur Decodierung von codierten Daten, umfassend Quellendaten (S) und Redundanzdaten (R), wobei die Redundanzdaten (R) erhalten werden, indem bei der Codierung ein Fehlerkorrekturcode an die Quellendaten (S) angelegt wird, der geeignet ist, durch eine Erzeugungsmatrix dargestellt zu werden, umfassend in ihrer systematischen Form eine Identitätsmatrix und eine invertierbare Übergangsmatrix von den Quellendaten zu den Redundanzdaten (P),
**dadurch gekennzeichnet, dass** das Verfahren einen Decodierungsschritt (12) umfasst, der gleichzeitig den Fehlerkorrekturcode, primal Fehlerkorrekturcode genannt, und einen dual Code des primal Fehlerkorrekturcodes, dual Fehlerkorrekturcode genannt, einsetzt,
wobei ein dual Code als der Code definiert ist, der eine inverse Übergangsmatrix ($P^{-1}$) zu jener (P) des primal Fehlerkorrekturcodes hat, und der es ermöglicht, die Quellendaten des primal Fehlerkorrekturcodes auf Basis seiner Redundanzdaten auszudrücken, wobei diese Definition des dual Codes keine Anforderung einer Orthogonalität zwischen den Vektoren des primal Codes und des dual Codes stellt, wobei die Decodierung erfolgt, indem ein modifizierter Tanner-Graph, primal-dual Graph genannt, verwendet wird, der erhalten wird, indem ein Tanner-Graph entsprechend dem primal Fehlerkorrekturcode, primal Graph genannt, und ein Tanner-Graph entsprechend dem dual Fehlerkorrekturcode, dual Graph genannt, übereinandergelegt werden,
wobei das Übereinanderlegen darin besteht, die Eingangsvariablen (x0, ... x5) des primal Graphen mit den Eingangsvariablen (x0, ... x5) des dual Graphen entsprechend denselben Quellendaten zwei und zwei zu verbinden, und die Ausgangsvariablen (r0, ... r5) des primal Graphen mit den Ausgangsvariablen (r0, ... r5) des dual Graphen entsprechend denselben Redundanzdaten zwei und zwei zu verbinden.

2. Decodierungsverfahren nach Anspruch 1, **dadurch gekennzeichnet, dass** jede Eingangs- oder Ausgangsvariable des primal-dual Graphen mit einem Paar von Anforderungen verbunden ist, umfassend eine Anforderung vom Egalitätstyp und eine Anforderung vom Modulo-2-Additionstyp,
und dass das Verfahren einen Schritt der Bestimmung mindestens einer internen Variablen in dem primal-dual Graphen umfasst, welcher einsetzt:

* für eine Anforderung vom Modulo-2-Additionstyp:

- einen Schritt der Transformation der mit der Anforderung vom Modulo-2-Additionstyp verbundenen Variablen vom realen Bereich in den komplexen Bereich;
- einen Schritt der Addition im komplexen Bereich;
- einen Schritt der Transformation des Resultats des Additionsschrittes vom komplexen Bereich in den realen Bereich;

* für eine Anforderung vom Egalitätstyp:

    - einen Schritt der Addition im realen Bereich.

3. Decodierungsverfahren nach Anspruch 2, **dadurch gekennzeichnet, dass** die Transformationsschritte eine nicht lineare Funktion NL einsetzen, so dass:

$$\begin{cases} NL[x] = \log\left[\dfrac{1 - \exp[x]}{1 + \exp[x]}\right] & si \quad x \neq 0 \\ \quad NL[x] = 0 & si \quad x = 0 \end{cases}.$$

4. Decodierungsverfahren nach Anspruch 1, **dadurch gekennzeichnet, dass** jede Eingangs- oder Ausgangsvariable des primal-dual Graphen mit einem Paar von Anforderungen verbunden ist, umfassend eine Anforderung vom Egalitätstyp und eine Anforderung vom Modulo-2-Additionstyp, und dass das Verfahren mindestens eine Decodierungsiteration einsetzt, umfassend:

    - eine vordere Ausbreitungsphase, die darin besteht, die internen Variablen im primaldual Graphen, die mit einer Anforderung vom Egalitätstyp verbunden sind, auszubreiten, um die internen Variablen im primal-dual Graphen, die mit einer Anforderung vom Modulo-2-Additionstyp verbunden sind, zu aktualisieren, und
    - eine hintere Ausbreitungsphase, die darin besteht, die internen Variablen im primaldual Graphen, die mit einer Anforderung vom Modulo-2-Additionstyp verbunden sind, auszubreiten, um die internen Variablen im primal-dual Graphen, die mit einer Anforderung vom Egalitätstyp verbunden sind, zu aktualisieren.

5. Decodierungsverfahren nach Anspruch 4, **dadurch gekennzeichnet, dass** die vordere Ausbreitungsphase die folgenden Unterschritte für jedes Paar von Anforderungen, das mit einer Eingangs- oder Ausgangsvariablen des primal-dual Graphen verbunden ist, einsetzt:

    - Bestimmung eines vorderen Wahrscheinlichkeitswerts $V_0^F(t)$, (t), der der Eingangs- oder Ausgangsvariaulen des primaldual Graphen zugeordnet ist, wobei eine Addition im realen Bereich eingesetzt wird, so dass:

$$v_0^F(t) = \frac{\sum_{i=1}^{d} v_i(t)}{d},$$

    - Bestimmung von Wahrscheinlichkeitswerten, die den Variablen zugeordnet sind, die mit der Anforderung vom Modulo-2-Additionstyp verbunden sind, nach Transformation vom realen Bereich in den komplexen Bereich, transformierte vordere Wahrscheinlichkeitswerte genannt, so dass:

    * die Eingangs- oder Ausgangsvariable des primal-dual Graphen nach der Transformation in folgender Form ausgedrückt wird: $w_0^F(t) = NL\left[v_0(0) + v_0^F(t)\right]$ und

$$s_0^F(t) = signe\left[v_0(0) + v_0^F(t)\right];$$

    * die internen Variablen nach der Transformation in folgender Form ausgedrückt werden: $w_l^F(t) = NL\left[v_l'(t)\right]$ und $s_l^F(t) = signe\left[v_l'(t)\right]$ für $\in \{1, ...d\}$;

    - Aktualisierung der transformierten vorderen Wahrscheinlichkeitswerte, wobei eine Addition im komplexen Bereich eingesetzt wird, so dass:

$$w_l^F(t+1) = w_0^F(t) + \frac{\sum_{i=1,i\neq l}^{d} w_i^F(t)}{d-1} \quad \text{und} \quad s_l^F(t+1) = \prod_{i=0,i\neq l}^{d} s_i^F(t)$$

- Aktualisierung der Werte der internen Variablen, die mit der Anforderung vom Modulo-2-Additionstyp verbunden sind, wobei eine Transformation der aktualisierten transformierten vorderen Wahrscheinlichkeitswerte vom komplexen Bereich in den realen Bereich eingesetzt wird, so dass:

$$v_l'(t+1) = s_l^F(t+1)NL\left[w_l^F(t+1)\right] ;$$

wobei:

- $v_0(0)$ ein Ausgangswert ist, der der Eingangsoder Ausgangsvariablen des primal-dual Graphen zugeordnet ist;
- $v_i(t)$ die internen Variablen sind, die mit der Anforderung vom Egalitätstyp verbunden sind;
- $v_1(t)$ die internen Variablen sind, die mit der Anforderung vom Modulo-2-Additionstyp verbunden sind;
- d der Anforderungsgrad in Verbindung mit einer Anforderung des primal-dual Graphen ist;
- $i \in \{1, ... d\}$, $1 \in \{1, ... d\}$;
- NL[x] eine nicht lineare Funktion ist, so dass:

$$\begin{cases} NL[x] = \log\left[\dfrac{1-\exp[x]}{1+\exp[x]}\right] & si \quad x \neq 0 \\ NL[x] = 0 & si \quad x = 0 \end{cases}.$$

6. Decodierungsverfahren nach Anspruch 4, **dadurch gekennzeichnet, dass** die hintere Ausbreitungsphase die folgenden Unterschritte für jedes Paar von Anforderungen, das mit einer Eingangs- oder Ausgangsvariablen des primal-dual Graphen verbunden ist, einsetzt:

- Bestimmung von Wahrscheinlichkeitswerten, die den Variablen zugeordnet sind, die mit der Anforderung vom Modulo-2-Additionstyp verbunden sind, nach Transformation vom realen Bereich in den komplexen Bereich, transformierte hintere Wahrscheinlichkeitswerte genannt, so dass:

* die internen Variablen nach der Transformation in folgender Form ausgedrückt werden:

$$w_l^B(t) = NL\left[v_l'(t)\right] \quad \text{und} \quad s_l^B(t) = signe\left[v_l'(t)\right], \text{ für } 1 \in \{1, ... d\};$$

* die Eingangs- oder Ausgangsvariable des primal-dual Graphen nach der Transformation in folgender Form ausgedrückt wird: $w_0^B(t) = \dfrac{\sum_{l=1}^{d} w_l^B(t)}{d}$ und

$$s_0^B(t) = \left(\prod_{l=1}^{d} s_l^B(t)\right) ;$$

- Bestimmung eines hinteren Wahrscheinlichkeitswerts $v_0^B(t)$ der der Eingangs- oder Ausgangsvariablen des primaldual Graphen zugeordnet ist, wobei eine Transformation vom komplexen Bereich in den realen Bereich der Eingangs- oder Ausgangsvariablen nach der Transformation eingesetzt wird, so dass:

$$v_0^B(t) = s_0^{B(t)} \times NL\left[w_0^B(t)\right]$$

- Aktualisierung der Werte der internen Variablen, die mit der Anforderung vom Egalitätstyp verbunden sind, wobei eine Addition im realen Bereich eingesetzt wird, so dass:

$$v_l(t+1) = v_0(0) + v_0^B(t) + \frac{\sum_{i=1, i \neq l}^{d} v_i(t)}{d-1},$$

- Aktualisierung der Eingangs- oder Ausgangsvariablen des primal-dual Graphen, so dass:

$$v_0(t+1) = v_0^F(t) + v_0(0) + v_0^B(t) ;$$

wobei:

- $v_0(0)$ ein Ausgangswert ist, der der Eingangsoder Ausgangsvariablen des primal-dual Graphen zugeordnet ist;
- $v_i(t)$ die internen Variablen sind, die mit der Anforderung vom Egalitätstyp verbunden sind;
- $v_1(t)$ die internen Variablen sind, die mit der Anforderung vom Modulo-2-Additionstyp verbunden sind;
- d der Anforderungsgrad in Verbindung mit einer Anforderung des primal-dual Graphen ist;
- $i \in \{1, ... d\}, 1 \in \{1, ... d\}$;
- NL[x] eine nicht lineare Funktion ist, so dass:

$$\begin{cases} NL[x] = \log\left[\dfrac{1 - \exp[x]}{1 + \exp[x]}\right] & si \quad x \neq 0 \\ \quad NL[x] = 0 & si \quad x = 0 \end{cases}.$$

**7.** Decodierungsverfahren nach Anspruch 4, **dadurch gekennzeichnet, dass** es einen vorherigen Schritt der Initialisierung der Eingangsvariablen, der Ausgangsvariablen und der internen Variablen des primal-dual Graphen auf Null umfasst.

**8.** Decodierungsverfahren nach Anspruch 1, **dadurch gekennzeichnet, dass** mindestens zwei Eingangsoder Ausgangsvariablen des primal-dual Graphen mit einem selben Paar von Anforderungen, umfassend eine Anforderung vom Egalitätstyp und eine Anforderung vom Modulo-2-Additionstyp, verbunden sind.

**9.** Vorrichtung zur Decodierung von codierten Daten, umfassend Quellendaten (S) und Redundanzdaten (R), wobei die Redundanzdaten (R) erhalten werden, indem bei der Codierung ein Fehlerkorrekturcode an die Quellendaten (S) angelegt wird, der geeignet ist, durch eine Erzeugungsmatrix dargestellt zu werden, umfassend in ihrer systematischen Form eine Identitätsmatrix und eine invertierbare Übergangsmatrix von den Quellendaten zu den Redundanzdaten (P),
**dadurch gekennzeichnet, dass** die Vorrichtung ein Modul zur Decodierung (12) umfasst, das gleichzeitig den Fehlerkorrekturcode, primal Fehlerkorrekturcode genannt, und einen dual Code des primal Fehlerkorrekturcodes, dual Fehlerkorrekturcode genannt, einsetzt,
wobei ein dual Code als der Code definiert ist, der eine inverse Übergangsmatrix ($P^{-1}$) zu jener (P) des primal Fehlerkorrekturcodes hat, und der es ermöglicht, die Quellendaten des primal Fehlerkorrekturcodes auf Basis seiner Redundanzdaten auszudrücken, wobei diese Definition des dual Codes keine Anforderung einer Orthogonalität zwischen den Vektoren des primal Codes und des dual Codes stellt, wobei die Decodierung erfolgt, indem ein modifizierter Tanner-Graph, primal-dual Graph genannt, verwendet wird, der erhalten wird, indem ein Tanner-Graph entsprechend dem primal Fehlerkorrekturcode, primal Graph genannt, und ein Tanner-Graph entsprechend dem dual Fehlerkorrekturcode, dual Graph genannt, übereinandergelegt werden,
wobei das Übereinanderlegen darin besteht, die Eingangsvariablen (x0, ... x5) des primal Graphen mit den Eingangsvariablen (x0, ... x5) des dual Graphen entsprechend denselben Quellendaten zwei und zwei zu verbinden, und die Ausgangsvariablen (r0, ... r5) des primal Graphen mit den Ausgangsvariablen (r0, ... r5) des dual Graphen entsprechend denselben Redundanzdaten zwei und zwei zu verbinden.

**10.** Verfahren zur Codierung von Quellendaten (S), das codierte Daten liefert, umfassend die Quellendaten (S) und Redundanzdaten (R),
**dadurch gekennzeichnet, dass** das Verfahren einen Codierungsschritt (11) umfasst, der gleichzeitig einsetzt:

- einen Fehlerkorrekturcode, primal Fehlerkorrekturcode genannt, der geeignet ist, durch eine Erzeugungsmatrix dargestellt zu werden, umfassend in ihrer systematischen Form, eine Identitätsmatrix und eine invertierbare Übergangsmatrix von den Quellendaten zu den Redundanzdaten (P), und
- einen dual Code des primal Fehlerkorrekturcodes, dual Fehlerkorrekturcode genannt,

wobei ein dual Code als der Code definiert ist, der eine inverse Übergangsmatrix ($P^{-1}$) zu jener (P) des primal Fehlerkorrekturcodes hat, und der es ermöglicht, die Quellendaten des primal Fehlerkorrekturcodes auf Basis seiner Redundanzdaten auszudrücken, wobei diese Definition des dual Codes keine Anforderung einer Orthogonalität zwischen den Vektoren des primal Codes und des dual Codes stellt,
wobei der Codierungsschritt einen modifizierten Tanner-Graphen, primal-dual Graph genannt, einsetzt, der erhalten wird, indem ein Tanner-Graph entsprechend dem primal Fehlerkorrekturcode, primal Graph genannt, und ein Tanner-Graph entsprechend dem dual Fehlerkorrekturcode, dual Graph genannt, übereinandergelegt werden,
wobei das Übereinanderlegen darin besteht, die Eingangsvariablen (x0, ... x5) des primal Graphen mit den Eingangsvariablen (x0, ... x5) des dual Graphen entsprechend denselben Quellendaten zwei und zwei zu verbinden, und die Ausgangsvariablen (r0, ... r5) des primal Graphen mit den Ausgangsvariablen (r0, ... r5) des dual Graphen entsprechend denselben Redundanzdaten zwei und zwei zu verbinden.

11. Vorrichtung zur Codierung von Quellendaten (S), die codierte Daten liefert, umfassend die Quellendaten (S) und Redundanzdaten (R),
**dadurch gekennzeichnet, dass** die Vorrichtung ein Codierungsmodul (11) umfasst, das gleichzeitig einsetzt:

- einen Fehlerkorrekturcode, primal Fehlerkorrekturcode genannt, der geeignet ist, durch eine Erzeugungsmatrix dargestellt zu werden, umfassend in ihrer systematischen Form, eine Identitätsmatrix und eine invertierbare Übergangsmatrix von den Quellendaten zu den Redundanzdaten (P), und
- einen dual Code des primal Fehlerkorrekturcodes, dual Fehlerkorrekturcode genannt,

wobei ein dual Code als der Code definiert ist, der eine inverse Übergangsmatrix ($P^{-1}$) zu jener (P) des primal Fehlerkorrekturcodes hat, und der es ermöglicht, die Quellendaten des primal Fehlerkorrekturcodes auf Basis seiner Redundanzdaten auszudrücken, wobei diese Definition des dual Codes keine Anforderung einer Orthogonalität zwischen den Vektoren des primal Codes und des dual Codes stellt,
wobei das Codierungsmodul einen modifizierten Tanner-Graphen, primal-dual Graph genannt, einsetzt, der erhalten wird, indem ein Tanner-Graph entsprechend dem primal Fehlerkorrekturcode, primal Graph genannt, und ein Tanner-Graph entsprechend dem dual Fehlerkorrekturcode, dual Graph genannt, übereinandergelegt werden,
wobei das Übereinanderlegen darin besteht, die Eingangsvariablen (x0, ... x5) des primal Graphen mit den Eingangsvariablen (x0, ... x5) des dual Graphen entsprechend denselben Quellendaten zwei und zwei zu verbinden, und die Ausgangsvariablen (r0, ... r5) des primal Graphen mit den Ausgangsvariablen (r0, ... r5) des dual Graphen entsprechend denselben Redundanzdaten zwei und zwei zu verbinden.

12. Vorrichtung zur Codierung und Decodierung von Daten,
**dadurch gekennzeichnet, dass** sie ein Codierungs- und Decodierungsmodul umfasst, das gleichzeitig einsetzt:

- einen Fehlerkorrekturcode, primal Fehlerkorrekturcode genannt, der geeignet ist, durch eine Erzeugungsmatrix dargestellt zu werden, umfassend in ihrer systematischen Form, eine Identitätsmatrix und eine invertierbare Übergangsmatrix von den Quellendaten zu den Redundanzdaten (P), und
- einen dual Code des primal Fehlerkorrekturcodes, dual Fehlerkorrekturcode genannt,

wobei ein dual Code als der Code definiert ist, der eine inverse Übergangsmatrix ($P^{-1}$) zu jener (P) des primal Fehlerkorrekturcodes hat, und der es ermöglicht, die Quellendaten des primal Fehlerkorrekturcodes auf Basis seiner Redundanzdaten auszudrücken, wobei diese Definition des dual Codes keine Anforderung einer Orthogonalität zwischen den Vektoren des primal Codes und des dual Codes stellt,
wobei das Codierungs- und Decodierungsmodul einen modifizierten Tanner-Graphen, primal-dual Graph genannt, einsetzt, der erhalten wird, indem ein Tanner-Graph entsprechend dem primal Fehlerkorrekturcode, primal Graph genannt, und ein Tanner-Graph entsprechend dem dual Fehlerkorrekturcode, dual Graph genannt, übereinandergelegt werden,
wobei das Übereinanderlegen darin besteht, die Eingangsvariablen (x0, ... x5) des primal Graphen mit den Eingangsvariablen (x0, ... x5) des dual Graphen entsprechend denselben Quellendaten zwei und zwei zu verbinden, und die Ausgangsvariablen (r0, ... r5) des primal Graphen mit den Ausgangsvariablen (r0, ... r5) des dual Graphen entsprechend denselben Redundanzdaten zwei und zwei zu verbinden.

**13.** Computerprogramm, umfassend Befehle für den Einsatz eines Decodierungsverfahrens nach Anspruch 1 oder eines Codierungsverfahrens nach Anspruch 10, wenn das Programm von einem Prozessor ausgeführt wird.

**Claims**

**1.** Method for decoding coded data, comprising source data (S) and redundancy data (R),
said redundancy data (R) being obtained by applying, in the coding, an error correcting code to said source data (S), capable of being represented by a generating matrix comprising, in its systematic form, an identity matrix and an invertible source data to redundancy data transition matrix (P),
**characterized in that** said method comprises a decoding step (12) simultaneously implementing said error correcting code, called primal error correcting code, and a dual code of said primal error correcting code, called dual error correcting code, a dual code being defined as the code having an inverse transition matrix $(P^{-1})$ of that (P) of the primal error correcting code and which makes it possible to express the source data of the primal error correcting code from its redundancy data, this definition of the dual code not imposing any constraint of orthogonality between the vectors of the primal code and of the dual code, the decoding being performed by using a modified Tanner graph, called primal-dual graph, obtained by superimposing a Tanner graph corresponding to said primal error correcting code, called primal graph, and a Tanner graph corresponding to said dual error correcting code, called dual graph, said superimposition consisting in connecting, two-by-two, the input variables ($x0,...,x5$) of said primal graph to the input variables ($x0,...,x5$) of said dual graph corresponding to the same source data, and in connecting, two-by-two, the output variables ($r0,..., r5$) of said primal graph to the output variables ($r0,...,r5$) of said dual graph corresponding to the same redundancy data.

**2.** Decoding method according to Claim 1, **characterized in that** each input or output variable of the primal-dual graph is connected to a pair of constraints comprising a constraint of equality type and a constraint of modulo 2 addition type, and **in that** said method comprises a step of determination of at least one variable internal to said primal-dual graph implementing:

- for a constraint of modulo 2 addition type:

  o a step of transformation, from the real domain to the complex domain, of the variables connected to said constraint of modulo 2 addition type;
  o a step of addition in the complex domain;
  o a step of transformation, from the complex domain to the real domain, of the result of said addition step;

- for a constraint of equality type:

  o a step of addition in the real domain.

**3.** Decoding method according to Claim 2, **characterized in that** said transformation steps implement a nonlinear function NL such that:

$$
\begin{cases}
NL[x] = \log\left[\dfrac{1 - \exp[x]}{1 + \exp[x]}\right] & \text{if } x \neq 0 \\
NL[x] = 0 & \text{if } x = 0
\end{cases}
$$

**4.** Decoding method according to Claim 1, **characterized in that** each input or output variable of the primal-dual graph is connected to a pair of constraints comprising a constraint of equality type and a constraint of modulo 2 addition type, and **in that** said method implements at least one decoding iteration, comprising:

- a forward propagation phase, consisting in propagating the variables internal to the primaldual graph connected to a constraint of equality type to update the variables internal to the primal-dual graph connected to a constraint of modulo 2 addition type, and

- a backward propagation phase, consisting in propagating the variables internal to the primaldual graph connected to a constraint of modulo 2 addition type to update the variables internal to the primal-dual graph connected to a constraint of equality type.

5.  Decoding method according to Claim 4, **characterized in that** said forward propagation phase implements the following substeps, for each pair of constraints connected to an input or output variable of the primal-dual graph:

- determination of a forward likelihood value $v_0^F(t)$ assigned to said input or output variable of the primal-dual graph, implementing an addition in the real domain, such that:

$$v_0^F(t) = \frac{\sum_{i=1}^d v_i(t)}{d},$$

- determination of likelihood values assigned to the variables connected to the constraint of modulo 2 addition type, after transformation from the real domain to the complex domain, called transformed forward likelihood values, such that:

o said input or output variable of the primaldual graph after transformation is expressed in the form:

$$w_0^F(t) = NL\left[v_0(0) + v_0^F(t)\right] \text{ and } s_0^F(t) = \text{sign}\left[v_0(0) + v_0^F(t)\right];$$

o the internal variables after transformation are expressed in the form: $w_l^F(t) = NL\left[v_l'(t)\right]$ and

$$s_l^F(t) = \text{sign}\left[v_l'(t)\right] \quad \text{for} \quad l \in \{1,...,d\};$$

- updating of the transformed forward likelihood values, implementing an addition in the complex domain, such that:

$$w_l^F(t+1) = w_0^F(t) + \frac{\sum_{i=1,i\neq l}^d w_i^F(t)}{d-1} \quad \text{and} \quad s_l^F(t+1) = \prod_{i=0,i\neq l}^d s_i^F(t)$$

- updating of the values of the internal variables connected to the constraint of modulo 2 addition type, implementing a transformation from the complex domain to the real domain of the updated transformed forward likelihood values, such that:

$$v_l'(t+1) = s_l^F(t+1)NL\left[w_l^F(t+1)\right];$$

with:

- $v_0(0)$ being an initial value assigned to said input or output variable of the primal-dual graph;
- $v_i(t)$ being the internal variables connected to the constraint of equality type;
- $v'_1(t)$ being the internal variables connected to the constraint of modulo 2 addition type;
- d being the degree of constraints associated with a constraint of the primal-dual graph; - $i \in \{1,..,d\}$, $1 \in \{1,...,d\}$;
- $NL[x]$ being a nonlinear function such that:

$$\begin{cases} NL[x] = \log\left[\dfrac{1 - \exp[x]}{1 + \exp[x]}\right] & \text{if } x \neq 0 \\ NL[x] = 0 & \text{if } x = 0 \end{cases}$$

6. Decoding method according to Claim 4, **characterized in that** said backward propagation phase implements the following substeps, for each pair of constraints connected to an input or output variable of the primal-dual graph:

- determination of likelihood values assigned to the variables connected to the constraint of modulo 2 addition type, after transformation from the real domain to the complex domain, called transformed backward likelihood values, such that:

o the internal variables after transformation are expressed in the form:

$$w_l^B(t) = NL\left[v_l'(t)\right] \text{ and } s_l^B(t) = \text{sign}\left[v_l'(t)\right], \text{ for}$$

$1 \in \{1,...,d\}$;
o said input or output variable of the primaldual graph after transformation is expressed in the form:

$$w_0^B(t) = \frac{\sum_{l=1}^{d} w_l^B(t)}{d}$$

and

$$s_0^B(t) = \left(\prod_{l=1}^{d} s_l^B(t)\right);$$

- determination of a backward likelihood value $\mathbb{C}$ assigned to said input or output variable of the primal-dual graph, implementing a transformation from the complex domain to the real domain of the input or output variable after transformation, such that:

$$v_0^B(t) = s_0^{B(t)} \times NL\left[w_0^B(t)\right]$$

- updating of the values of the internal variables connected to the constraint of equality type, implementing an addition in the real domain, such that:

$$v_l(t+1) = v_0(0) + v_0^B(t) + \frac{\sum_{i=1,i\neq l}^{d} v_i(t)}{d-1},$$

- updating of said input or output variable of the primal-dual graph, such that:

$$v_0(t+1) = v_0^F(t) + v_0(0) + v_0^B(t);$$

with:

- $v_0(0)$ being an initial value assigned to said input or output variable of the primal-dual graph;
- $v_i(t)$ being the internal variables connected to the constraint of equality type;
- $v_1(t)$ being the internal variables connected to the constraint of modulo 2 addition type;
- d being the degree of constraints associated with a constraint of the primal-dual graph;
- i ∈ {1,...,d}, 1 ∈ {1,...,d};
- $NL[x]$ being a nonlinear function such that:

$$\begin{cases} NL[x] = \log\left[\dfrac{1 - \exp[x]}{1 + \exp[x]}\right] & if \; x \neq 0 \\ NL[x] = 0 & if \; x = 0 \end{cases}$$

7. Decoding method according to Claim 4, **characterized in that** it comprises a preliminary step of initialization of the input variables, of the output variables, and of the internal variables of the primaldual graph at zero.

8. Decoding method according to Claim 1, **characterized in that** at least two input or output variables of the primal-dual graph are connected to a same pair of constraints comprising a constraint of equality type and a constraint of modulo 2 addition type.

9. Device for decoding coded data, comprising source data (S) and redundancy data (R),
said redundancy data (R) being obtained by applying, in the coding, an error correcting code to said source data (S), capable of being represented by a generating matrix comprising, in its systematic form, an identity matrix and an invertible source data to redundancy data transition matrix (P),
**characterized in that** said device comprises a decoding module (12) simultaneously implementing said error correcting code, called primal error correcting code, and a dual code of said primal error correcting code, called dual error correcting code, a dual code being defined as the code having an inverse transition matrix ($P^{-1}$) of that (P) of the primal error correcting code and which makes it possible to express the source data of the primal error correcting code from its redundancy data, this definition of the dual code not imposing any constraint of orthogonality between the vectors of the primal code and of the dual code, the decoding being performed by using a modified Tanner graph, called primal-dual graph, obtained by superimposing a Tanner graph corresponding to said primal error correcting code, called primal graph, and a Tanner graph corresponding to said dual error correcting code, called dual code,
said superimposition consisting in connecting, two-by-two, the input variables ($x0$,..., $x5$) of said primal graph to the input variables ($x0$,..., $x5$) of said dual graph corresponding to the same source data, and in connecting, two-by-two, the output variables ($r0$,..., $r5$) of said primal graph to the output variables ($r0$,..., $r5$) of said dual graph corresponding to the same redundancy data.

10. Method for coding source data (S), delivering coded data comprising said source data (S) and redundancy data (R), **characterized in that** said method comprises a coding step (11) simultaneously implementing:

- an error correcting code, called primal error correcting code, capable of being represented by a generating matrix comprising, in its systematic form, an identity matrix and an invertible source data to redundancy data transition matrix (P), and
- a dual code of said primal error correcting code, called dual error correcting code, a dual code being defined as the code having an inverse transition matrix ($P^{-1}$) of that (P) of the primal error correcting code and which makes it possible to express the source data of the primal error correcting code from its redundancy data, this definition of the dual code not imposing any constraint of orthogonality between the vectors of the primal code and of the dual code,

said coding step implementing a modified Tanner graph, called primal-dual graph, obtained by superimposing a Tanner graph corresponding to said primal error correcting code, called primal graph, and a Tanner graph corresponding to said dual error correcting code, called dual graph,
said superimposition consisting in connecting, two-by-two, the input variables ($x0$,..., $x5$) of said primal graph to the input variables ($x0$,..., $x5$) of said dual graph corresponding to the same source data, and in connecting, two-by-two, the output variables ($r0$,..., $r5$) of said primal graph to the output variables ($r0$,..., $r5$) of said dual graph corresponding to the same redundancy data.

**11.** Device for coding source data (S), delivering coded data comprising said source data (S) and redundancy data (R), **characterized in that** said device comprises a coding module (11) simultaneously implementing:

- an error correcting code, called primal error correcting code, capable of being represented by a generating matrix comprising, in its systematic form, an identity matrix and an invertible source data to redundancy data transition matrix (P), and
- a dual code of said primal error correcting code, called dual error correcting code, a dual code being defined as the code having an inverse transition matrix ($P^{-1}$) of that (P) of the primal error correcting code and which makes it possible to express the source data of the primal error correcting code from its redundancy data, this definition of the dual code not imposing any constraint of orthogonality between the vectors of the primal code and of the dual code,

said coding module implementing a modified Tanner graph, called primal-dual graph, obtained by superimposing a Tanner graph corresponding to said primal error correcting code, called primal graph, and a Tanner graph corresponding to said dual error correcting code, called dual graph,
said superimposition consisting in connecting, two-by-two, the input variables ($x0,..., x5$) of said primal graph to the input variables ($x0,..., x5$) of said dual graph corresponding to the same source data, and in connecting, two-by-two, the output variables ($r0,..., r5$) of said primal graph to the output variables ($r0,..., r5$) of said dual graph corresponding to the same redundancy data.

**12.** Device for coding and decoding data,
**characterized in that** it comprises a coding and decoding module simultaneously implementing:

- an error correcting code, called primal error correcting code, capable of being represented by a generating matrix comprising, in its systematic form, an identity matrix and an invertible source data to redundancy data transition matrix (P), and
- a dual code of said primal error correcting code, called dual error correcting code, a dual code being defined as the code having an inverse transition matrix ($P^{-1}$) of that (P) of the primal error correcting code and which makes it possible to express the source data of the primal error correcting code from its redundancy data, this definition of the dual code not imposing any constraint of orthogonality between the vectors of the primal code and of the dual code,

said coding and decoding module implementing a modified Tanner graph, called primal-dual graph, obtained by superimposing a Tanner graph corresponding to said primal error correcting code, called primal graph, and a Tanner graph corresponding to said dual error correcting code, called dual graph,
said superimposition consisting in connecting, two-by-two, the input variables ($x0,..., x5$) of said primal graph to the input variables ($x0,..., x5$) of said dual graph corresponding to the same source data, and in connecting, two-by-two, the output variables ($r0,..., r5$) of said primal graph to the output variables ($r0,..., r5$) of said dual graph corresponding to the same redundancy data.

**13.** Computer program comprising instructions for the implementation of a decoding method according to Claim 1 or of a coding method according to Claim 10 when said program is run by a processor.

Fig. 1

Fig. 2A

Fig. 2B

Fig. 2C

Fig. 3A

Fig. 3B

Fig. 3C

Fig. 4

Fig. 5A

Fig. 5B

Fig. 6A

Fig. 6B

**EP 2 766 996 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R.M. TANNER.** *IEEE Transactions on information theory »,* Février 2001, vol. 47
- **THORSTEN HEHN et al.** Multiple-bases belief-propagation decoding of high-density cyclic codes. *IEEE Transactions on Communications,* Janvier 2010, 1-8

- **PATRICK ADDE et al.** Near maximum likelihood soft-decision decoding of a particular class of rate-1/2 systematic linear block codes. *Electronics Letters,* 17 Février 2011, vol. 47 (4), 259-260
- **V.S. PLESS ; W.C. HUFFMAN.** *Handbook of coding theory,* vol. I, 177-294